# EUROPEAN PATENT APPLICATION

(11) **EP 4 719 003 A1**
(43) Date of publication of application: **01.04.2026**
(21) Application number: 25187189.3
(22) Date of filing: 03.07.2025
(51) Int. Cl.: H10F 39/18, H10F 39/00

(54) **IMAGE SENSOR AND ELECTRONIC APPARATUS INCLUDING THE SAME**

(30) Priority: 26.09.2024 KR 20240131040
(71) Applicant: Samsung Electronics Co., Ltd., Suwon-si, Gyeonggi-do 16677 (KR)
(72) Inventor: MUN, Sangeun, 16678 Suwon-si (KR); ROH, Sookyoung, 16678 Suwon-si (KR); LEE, Sangyun, 16678 Suwon-si (KR)
(74) Representative: Elkington and Fife LLP

(57) **Abstract**

An image sensor includes a sensor substrate including a plurality of photosensitive elements, and a nano-optical lens array including a plurality of nano-structures. The plurality of photosensitive elements include a first main photosensitive element and a first corner photosensitive element that sense the light of the first wavelength band and are arranged adjacent to each other in a first diagonal direction, the nano-optical lens array includes a first main meta-region corresponding to the first main photosensitive element and a first corner meta-region corresponding to the first corner photosensitive element. Nano-structures arranged in the first corner meta-region are arranged to have a symmetry based on a first axis and a second axis each passing through a center of the first corner meta-region, the first axis being parallel to the first diagonal direction and the second axis being parallel to a second diagonal direction that is different from the first diagonal direction.

## Description

### FIELD OF THE INVENTION

One or more example embodiments of the disclosure relate to an image sensor and an electronic apparatus including the same.

### BACKGROUND OF THE INVENTION

Image sensors generally sense a color of incident light by using a color filter. However, the color filter may have low light utilization efficiency because the color filter absorbs light of colors other than the color of incident light. For example, in the case in which a red-green-blue (RGB) color filter is used, only 1/3 of incident light is transmitted through the color filter and the other part of the incident light, that is, 2/3 of the incident light, is absorbed by the color filter. Thus, light utilization efficiency is only about 33%. Thus, in a color display apparatus or a color image sensor, most light loss occurs in a color filter.

### SUMMARY OF THE INVENTION

Provided are an image sensor including a nano-optical lens array that has improved optical efficiency, and an electronic apparatus including the image sensor.

Additional aspects will be set forth in part in the description which follows and, in part, will be apparent from the description, or may be learned by practice of the presented embodiments of the disclosure.

According to an aspect of an example embodiment of the disclosure, an image sensor includes: a sensor substrate including a plurality of photosensitive elements; and a nano-optical lens array including a plurality of nano-structures, the nano-optical lens array being configured to separate, from an incident light, a light of a first wavelength band, a light of a second wavelength band that is different from the first wavelength band, and a light of a third wavelength band that is different from the first wavelength band and the second wavelength band, and condense the separated lights respectively onto the plurality of photosensitive elements, wherein the plurality of photosensitive elements include a first main photosensitive element and a first corner photosensitive element configured to each sense the light of the first wavelength band and arranged adjacent to each other in a first diagonal direction, the first corner photosensitive element having a size less than a size of the first main photosensitive element, wherein the nano-optical lens array includes a first main meta-region corresponding to the first main photosensitive element and a first corner meta-region corresponding to the first corner photosensitive element, and wherein nano-structures in the first corner meta-region are arranged to have a symmetry based on a first axis and a second axis as symmetric axes, the first axis passing through a center of the first corner meta-region and being parallel to the first diagonal direction and the second axis passing through the center of the first corner meta-region and being parallel to a second diagonal direction that is different from the first diagonal direction.

The nano-structures in the first corner meta-region may be arranged such that a size distribution thereof on the first axis may be different from a size distribution thereof on the second axis.

In the nano-structures in the first corner meta-region, a number of nano-structures located on the first axis may be different from a number of nano-structures located on the second axis.

The plurality of photosensitive elements may further include a second main photosensitive element and a second corner photosensitive element, each being configured to sense the light of the second wavelength band, a third main photosensitive element and a third corner photosensitive element, each being configured to sense the light of the third wavelength band, and a fourth main photosensitive element and a fourth corner photosensitive element, each being configured to sense the light of the first wavelength band. The first to the fourth main photosensitive elements may be arranged in a 2x2 array in a first direction forming an angle of 45° with respect to the second diagonal direction and a second direction perpendicular to the first direction, the second corner photosensitive element may be arranged adjacent to the second main photosensitive element in the first diagonal direction, the third corner photosensitive element may be arranged adjacent to the third main photosensitive element in the first diagonal direction, and the fourth corner photosensitive element may be arranged adjacent to the fourth main photosensitive element in a diagonal direction.

The nano-optical lens array may further include a second main meta-region corresponding to the second main photosensitive element, and a second corner meta-region corresponding to the second corner photosensitive element, and the nano-structures in the second corner meta-region may be arranged to have a symmetry based on a third axis and a fourth axis as symmetric axes, the third axis passing through a center of the second corner meta-region and being parallel to the first diagonal direction and the fourth axis passing through the center of the second corner meta-region and being parallel to the second diagonal direction.

The nano-structures in the second corner meta-region may be arranged such that a size distribution thereof on the third axis may be different from a size distribution on the fourth axis.

The nano-optical lens array may further include a third main meta-region corresponding to the third main photosensitive element, and a third corner meta-region corresponding to the third corner photosensitive element, and the nano-structures in the third corner meta-region may be arranged to have a symmetry based on a fifth axis and a sixth axis as symmetric axes, the fifth axis passing through a center of the third corner meta-region and being parallel to the first diagonal direction and the sixth axis passing through the center of the third corner meta-region and being parallel to the second diagonal direction, and a size distribution of the nano-structures in the third corner meta-region on the fifth axis may be different from a size distribution thereof on the sixth axis.

The nano-optical lens array may further include a second main meta-region corresponding to the second main photosensitive region, a third main meta-region corresponding to the third main photosensitive region, a fourth main meta-region corresponding to the fourth main photosensitive element, a second corner meta-region corresponding to the second corner photosensitive element, a third corner meta-region corresponding to the third corner photosensitive element, and a fourth corner meta-region corresponding to the fourth corner photosensitive element, an arrangement of the nano-structures in the first main meta-region may be the same as an arrangement of nano-structures in the fourth main meta-region, and an arrangement of the nano-structures in the first corner meta-region may be the same as an arrangement of nano-structures in the fourth corner meta-region.

The first main photosensitive element and the fourth main photosensitive element may be configured to sense a green light, the second main photosensitive element may be configured to sense a red light, and the third main photosensitive element may be configured to sense a blue light.

The nano-optical lens array may include a first main green light condensing region configured to condense the green light onto the first main photosensitive element, a first corner green light condensing region configured to condense the green light onto the first corner photosensitive element, a main red light condensing region configured to condense the red light onto the second main photosensitive element, a corner red light condensing region configured to condense the red light onto the second corner photosensitive element, a main blue light condensing region configured to condense the blue light onto the third main photosensitive element, and a corner blue light condensing region configured to condense the blue light onto the third corner photosensitive element.

A width of the first corner green light condensing region in the first diagonal direction may be less than or equal to a width of the first corner meta-region in the first diagonal direction.

A width of the first corner green light condensing region in the second diagonal direction may be greater than a width of the first corner meta-region in the second diagonal direction.

A size of the first corner green light condensing region may be less than or equal to three times of a size of the first corner meta-region.

The nano-structures in the first corner green light condensing region may be arranged such that a size distribution thereof on the first axis may be different from a size distribution thereof on the second axis.

A width of the first main green light condensing region in the first diagonal direction may be greater than or equal to a width of the first main meta-region in the first diagonal direction, and a width of the first main green light condensing region in the second diagonal direction may be greater than a width of the first main meta-region in the second diagonal direction.

The nano-optical lens array may further include a second corner meta-region corresponding to the second corner photosensitive element, a size of the corner red light condensing region may be greater than a size of the second corner meta-region, and a width of the corner red light condensing region in the second diagonal direction may be greater than or equal to a width of the corner red light condensing region in the first diagonal direction.

The nano-optical lens array may further include a second main meta-region corresponding to the second main photosensitive element, a size of the main red light condensing region may be greater than a size of the second main meta-region, and a width of the main red light condensing region in the second diagonal direction may be greater than or equal to a width of the main red light condensing region in the first diagonal direction.

The nano-optical lens array may further include a third corner meta-region corresponding to the third corner photosensitive element, a size of the corner blue light condensing region may be greater than a size of the third corner meta-region, and a width of the corner blue light condensing region in the second diagonal direction may be greater than or equal to a width of the corner blue light condensing region in the first diagonal direction.

The nano-structures in the first main meta-region may be arranged to have a symmetry based on an axis that passes through a center of the first main meta-region and is parallel to the first diagonal direction and an axis that passes through the center of the first main meta-region and is parallel to the second diagonal direction, as symmetric axes, or to have a symmetry based on an axis that passes through the center of the first main meta-region and is parallel to a first direction that forms an angle of 45° with respect to the second diagonal direction and an axis that passes through the center of the first main meta-region and is parallel to a second direction perpendicular to the first direction, as symmetric axes.

According to an aspect of an example embodiment of the disclosure, an electronic apparatus includes a lens assembly configured to form an optical image of a subject, an image sensor configured to generate a signal by converting the optical image into an electrical signal, and a processor configured to process a signal generated by the image sensor.

The image sensor includes a sensor substrate including a plurality of photosensitive elements, and a nano-optical lens array including a plurality of nano-structures and being configured to separate, from an incident light, a light of a first wavelength band, a light of a second wavelength band that is different from the first wavelength band, and a light of a third wavelength band that is different from the first wavelength band and the second wavelength band and condense the separated lights respectively onto the plurality of photosensitive elements, wherein the plurality of photosensitive elements include a first main photosensitive element and a first corner photosensitive element, configured to each sense the light of the first wavelength band, and arranged adjacent to each other in a first diagonal direction, the first corner photosensitive element having a size less than a size of the first main photosensitive element, the nano-optical lens array includes a first main meta-region corresponding to the first main photosensitive element and a first corner meta-region corresponding to the first corner photosensitive element, and nano-structures arranged in the first corner meta-region are arranged to have a symmetry based on a first axis and a second axis as symmetric axes, the first axis passing through a center of the first corner meta-region and being parallel to the first diagonal direction and the second axis passing through the center of the first corner meta-region and being parallel to a second diagonal direction that is different from the first diagonal direction.

### BRIEF DESCRIPTION OF THE DRAWINGS

The above and other aspects, features, and advantages of certain example embodiments of the disclosure will be more apparent from the following description taken in conjunction with the accompanying drawings, in which:
FIG. 1 is a schematic block diagram of an image sensor according to an embodiment;
FIG. 2 is a plan view showing an example of a pixel arrangement in a pixel array of an image sensor according to an embodiment;
FIGS. 3A to 3C are plan views showing examples of another pixel arrangement that may be applied to a pixel array of an image sensor according to an embodiment;
FIG. 4 is a plan view showing an arrangement of a plurality of photosensitive elements in a sensor substrate provided in a pixel array of an image sensor according to an embodiment;
FIG. 5 is a plan view showing a division of regions in a nano-optical lens array provided in a pixel array of an image sensor according to an embodiment;
FIG. 6A is a plan view showing an example of an arrangement of nano-structures included in a nano-optical lens array provided in a pixel array of an image sensor according to an embodiment, and FIG. 6B is a plan view showing in detail the arrangement of nano-structures in a corner meta-region of FIG. 6A;
FIGS. 7A and 7B are cross-sectional views of a pixel array in the image sensor taken along lines A-A' and B-B' of FIG. 6A, respectively;
FIG. 8 is a plan view showing an example of corner light-condensing regions included in a nano-optical lens array in a pixel array of an image sensor according to an embodiment;
FIG. 9 is a plan view showing an example of main light-condensing regions included in a nano-optical lens array in a pixel array of an image sensor according to an embodiment;
FIGS. 10A, 10B and 10C are plan views showing examples of red light condensing regions, green light condensing regions, and blue light condensing regions included in a nano-optical lens array in a pixel array of an image sensor according to an embodiment;
FIGS. 11A and 11B are graphs showing color-separating performance of an image sensor according to an embodiment, as compared with a comparative example;
FIGS. 12A to 12C are plan views showing other examples of red light condensing regions, green light condensing regions, and blue light condensing regions included in a nano-optical lens array according to another embodiment;
FIG. 13 is a plan view showing an example of an arrangement of a plurality of nano-structures in a nano-optical lens array according to another embodiment;
FIG. 14 is a plan view showing an example of an arrangement of a plurality of nano-structures in a nano-optical lens array according to another embodiment;
FIG. 15 is a plan view showing an example of an arrangement of a plurality of nano-structures in a nano-optical lens array according to another embodiment;
FIG. 16 is a plan view showing an example of an arrangement of a plurality of nano-structures in a nano-optical lens array according to another embodiment;
FIG. 17A is a plan view showing an example of a symmetrical axis applied to an arrangement of a plurality of nano-structures in a nano-optical lens array according to another embodiment;
FIG. 17B is a plan view showing an example of a nano-optical lens array in which nano-structures are arranged based on the same symmetrical axis as FIG. 17A;
FIG. 18A is a plan view showing an example of a symmetrical axis applied to an arrangement of a plurality of nano-structures in a nano-optical lens array according to another embodiment;
FIG. 18B is a plan view showing an example of a nano-optical lens array in which nano-structures are arranged based on the same symmetrical axis as FIG. 18A;
FIG. 19 is a cross-sectional view of a pixel array in an image sensor including a nano-optical lens array according to another embodiment;
FIG. 20 is a block diagram of an electronic apparatus including an image sensor according to an embodiment;
FIG. 21 is a block diagram of a camera module included in the electronic apparatus of FIG. 20;
FIG. 22 is a block diagram of an electronic apparatus including a multi-camera module; and
FIG. 23 is a detailed block diagram of a camera module provided in the electronic apparatus of FIG. 22.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

The disclosure will be described in detail below with reference to accompanying drawings. Embodiments described herein are capable of various modifications and may be embodied in many different forms. In the drawings, like reference numerals denote like components, and sizes of components in the drawings may be exaggerated for convenience of explanation.

Hereinafter, it will be understood that when a layer, region, or component is referred to as being "above" or "on" another layer, region, or component, it may be in contact with and directly on the other layer, region, or component, and intervening layers, regions, or components may be present.

It will be understood that although the terms "first," "second," etc. may be used herein to describe various components, these components should not be limited by these terms. These components are only used to distinguish one component from another. These terms do not limit that materials or structures of components are different from one another.

An expression used in the singular encompasses the expression of the plural, unless it has a clearly different meaning in the context. It will be further understood that when a portion is referred to as "comprising" another component, the portion may not exclude another component but may further comprise another component unless the context states otherwise.

Also, the terms "... unit", "... module" used herein specify a unit for processing at least one function or operation, and this may be implemented with hardware or software or a combination of hardware and software.

The use of the term of "the above-described" and similar indicative terms may correspond to both the singular forms and the plural forms.

Also, the steps of all methods described herein may be performed in any suitable order unless otherwise indicated herein or otherwise clearly contradicted by context. Also, the use of all exemplary terms (for example, etc.) is only to describe technical detail, and the scope of rights is not limited by these terms unless the context is limited by the claims.

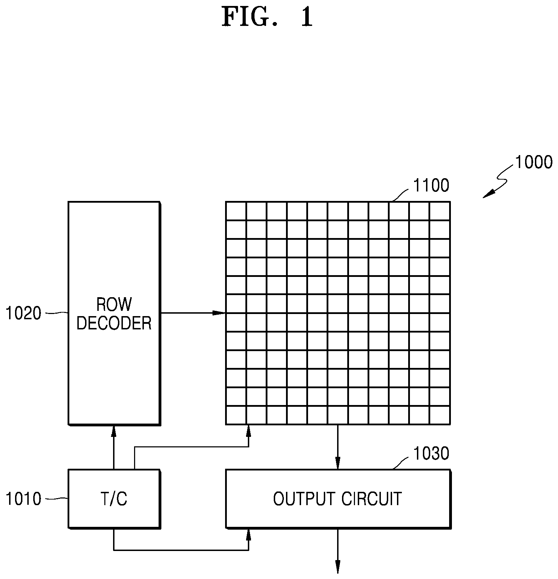

FIG. 1 is a schematic block diagram of an image sensor 1000 according to an embodiment. Referring to FIG. 1, the image sensor 1000 may include a pixel array 1100, a timing controller (T/C) 1010, a row decoder 1020, and an output circuit 1030. The image sensor 1000 may be a charge-coupled device (CCD) image sensor or a complementary metal oxide semiconductor (CMOS) image sensor.

The pixel array 1100 may include pixels that are two-dimensionally disposed in a plurality of rows and a plurality of columns. The row decoder 1020 may select one of the rows in the pixel array 1100 in response to a row address signal output from the timing controller 1010. The output circuit 1030 may output a photosensitive signal from a plurality of pixels disposed in the selected row in a column unit. To this end, the output circuit 1030 may include a column decoder and an analog-to-digital converter (ADC). For example, the output circuit 1030 may include a plurality of ADCs that are respectively disposed in columns between the column decoder and the pixel array 1100, or one ADC disposed at an output end of the column decoder. The timing controller 1010, the row decoder 1020, and the output circuit 1030 may be implemented as one chip or in separate chips. A processor for processing an image signal output from the output circuit 1030 may be implemented as one chip with the timing controller 1010, the row decoder 1020, and the output circuit 1030.

The pixel array 1100 may include a plurality of pixels that sense (or detect) light of different wavelengths. A pixel arrangement may be implemented in various ways.

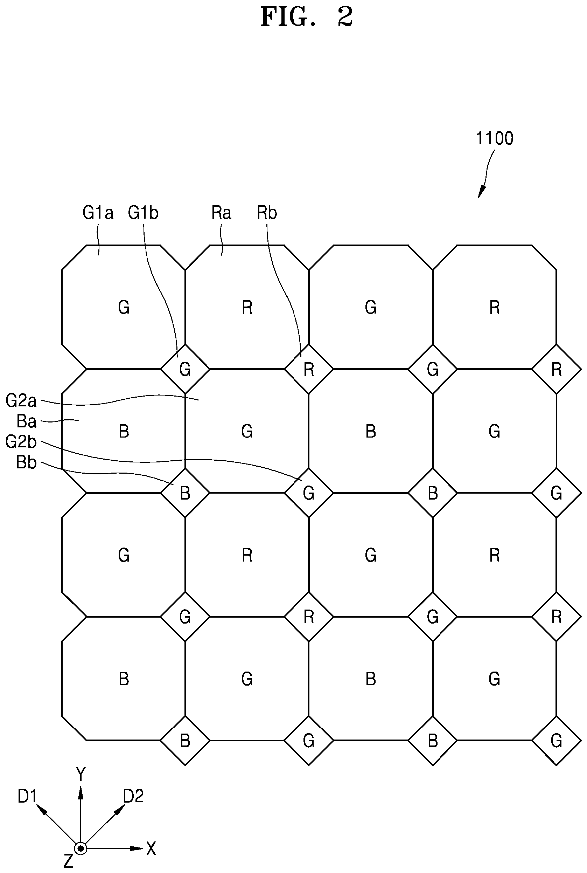

FIG. 2 shows an example of a pixel arrangement in the pixel array 1100 of the image sensor 1000. Referring to FIG. 2, the pixel array 1100 may include main pixels based on a Bayer pattern structure generally adopted in an image sensor, and corner pixels between the main pixels. The pixel array 1100 includes a plurality of unit pixel structures arranged two-dimensionally, and each of the plurality of unit pixel structures may include the main pixels and the corner pixels.

The main pixels may include a first green main pixel G1a, a red main pixel Ra, a blue main pixel Ba, and a second green main pixel G2a arranged in a 2x2 array in a first direction (X-direction) and a second direction (Y-direction). In the unit pixel structure, the red main pixel Ra and the blue main pixel Ba may be arranged in a second diagonal direction D2, and the first green main pixel G1a and the second green main pixel G2a may be arranged in a first diagonal direction D1 crossing the second diagonal direction D2.

In an entire arrangement of the main pixels, a first row in which a plurality of first green main pixels G1a and a plurality of red main pixels Ra are arranged alternately in the first direction (X-direction) and a second row in which a plurality of blue main pixels Ba and a plurality of second green main pixels G2a are arranged alternately in the first direction may be repeatedly arranged in the second direction (Y-direction), which is perpendicular to the first direction. The first direction and the second direction may be directions in which the pixel array 1100 extends on a plane defined by the first direction and the second direction. For example, one side of the pixel array 1100 may extend in the first direction and another side of the pixel array 1100 may extend in the second direction. The first diagonal direction D1 may be a direction between the first direction and the second direction, and the second diagonal direction D2 may be a direction between a direction opposite to the first direction (negative X-direction) and the second direction. The first diagonal direction D1 may be a direction forming an angle of 45° with the second direction (Y-direction). The second diagonal direction D2 may be a direction crossing the first diagonal direction D1 and may be perpendicular to the first diagonal direction D1.

The corner pixels may be arranged adjacent to corresponding main pixels in the first diagonal direction D1. For example, the corner pixels may include a first green corner pixel G1b arranged to be in contact with the first green main pixel G1a in the first diagonal direction D1, a red corner pixel Rb arranged to be in contact with the red main pixel Ra in the first diagonal direction D1, a blue corner pixel Bb arranged to be in contact with the blue main pixel Ba in the first diagonal direction D1, and a second green corner pixel G2b arranged in contact with the second green main pixel G2a in the first diagonal direction D1. When considering only the corner pixels, a plurality of first green corner pixels G1b and a plurality of red corner pixels Rb may be arranged alternately in the first direction, and a plurality of blue corner pixels Bb and a plurality of second green corner pixels G2b may be arranged alternately in the first direction on a different cross-section in the second direction.

In an arrangement of entire pixels in the pixel array 1100, the first green main pixel G1a, the first green corner pixel G1b, the second green main pixel G2a, and the second green corner pixel G2b may be alternately arranged along one cross-section in the first diagonal direction D1. Therefore, only the green pixels may be arranged on one cross-section in the first diagonal direction D1. The first green corner pixel G1b may be arranged between the first green main pixel G1a and the second green main pixel G2a in the first diagonal direction D1, and the second green corner pixel G2b may be arranged between the second green main pixel G2a and the first green main pixel G1a in the first diagonal direction D1. Also, in another cross-section parallel to the first diagonal direction D1, the red main pixel Ra, the red corner pixel Rb, the blue main pixel Ba, and the blue corner pixel Bb may be alternately arranged. The red corner pixel Rb may be arranged between the red main pixel Ra and the blue main pixel Ba in the first diagonal direction D1, and the blue corner pixel Bb may be arranged between the blue main pixel Ba and the red main pixel Ra in the first diagonal direction D1.

In one cross-section in the second diagonal direction D2, the first green main pixel G1a, the red corner pixel Rb, the second green main pixel G2a, and the blue corner pixel Bb may be alternately arranged. Therefore, the red corner pixel Rb and the blue corner pixel Bb may be arranged between two green main pixels in the second diagonal direction D2. In another cross-section parallel to the second diagonal direction D2, the red main pixel Ra, the first green corner pixel G1b, the blue main pixel Ba, and the second green corner pixel G2b may be alternately arranged. Therefore, the first green corner pixel G1b and the second green corner pixel G2b may be arranged between the red main pixel Ra and the blue main pixel Ba in the second diagonal direction D2.

Each of the main pixels may have a size (e.g., width or length of one side of the pixel) at least three times or greater than that of the corner pixel. For example, the width of the main pixel may be about 3 µm or greater, and the width of the corner pixel may be about 1 µm or less. Therefore, a light receiving area of the main pixel may be greater than that of the corner pixel, and a sensitivity of the main pixel may be higher than that of the corner pixel. The image sensor 1000 including the pixel array 1100 having the above pixel arrangement may be, for example, a high dynamic range (HDR) image sensor. In this case, in a low-luminance environment, an image may be generated by mainly using signals output from the main pixels, and in a high-luminance environment, an image may be generated by using all signals output from the main pixels and the corner pixels. Therefore, a contrast ratio of the image may be greatly improved by using the main pixels having relatively high sensitivity and the corner pixels having relatively low sensitivity.

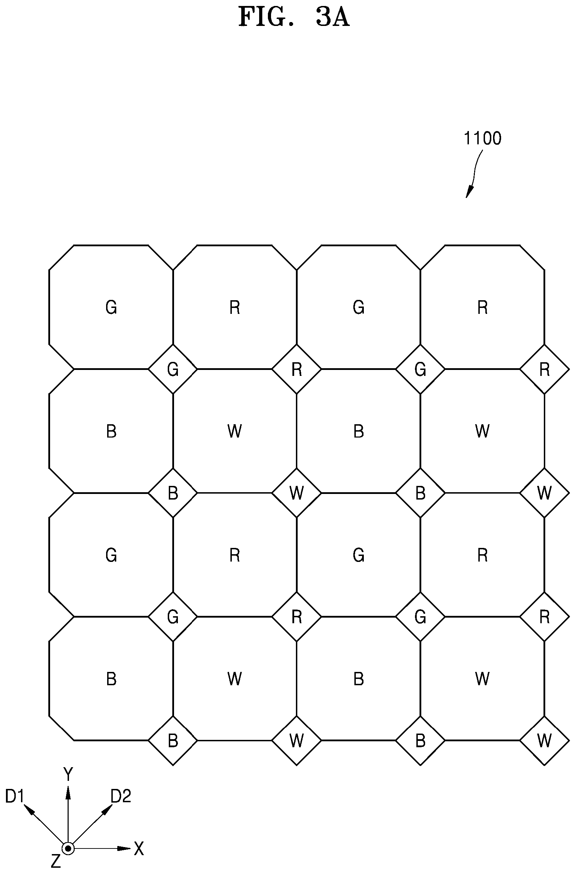

FIGS. 3A to 3C are plan views showing examples of another pixel arrangement that may be applied to a pixel array of an image sensor according to an embodiment.

FIG. 3A shows an arrangement based on RGBW, that is, includes main pixels and corner pixels representing green G, red R, blue B, and white W.

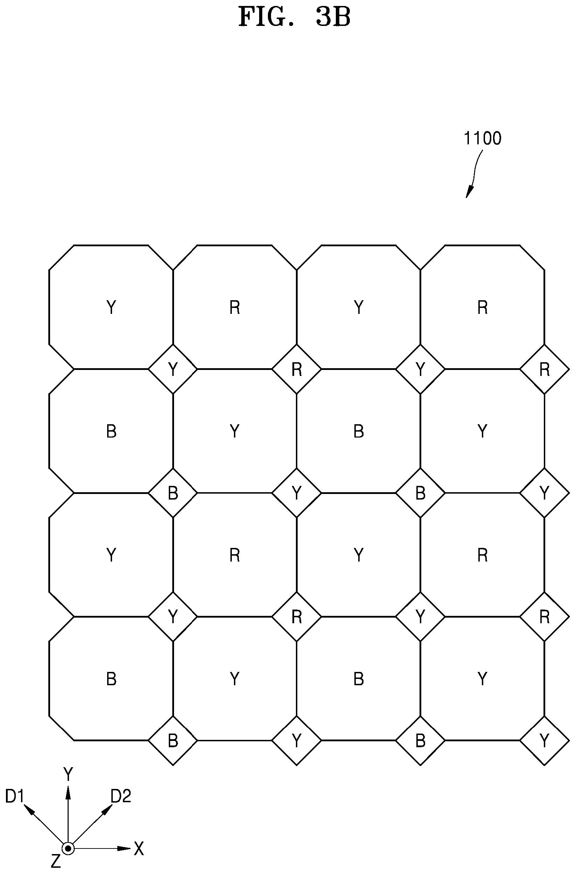

FIG. 3B shows an arrangement based RYYB, that is, includes main pixels and corner pixels representing yellow Y, red R, blue B, and yellow Y.

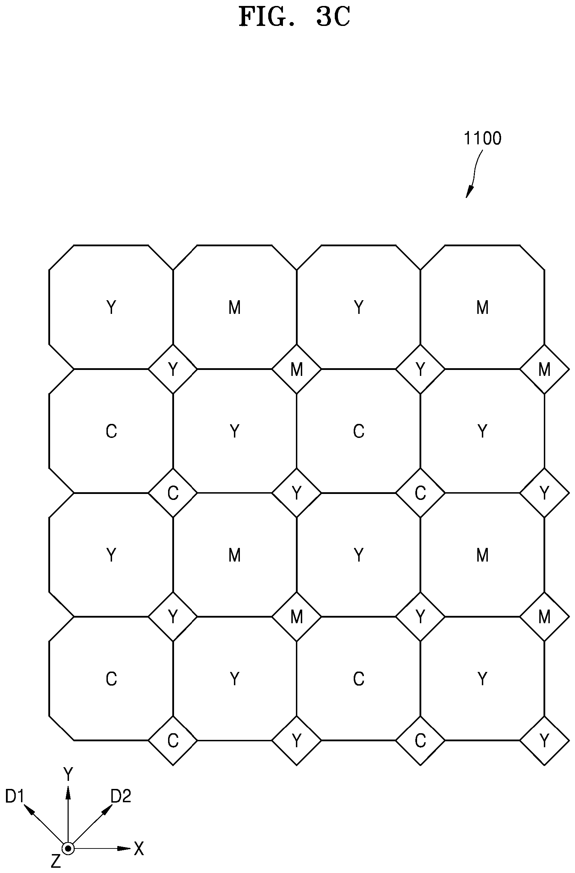

FIG. 3C shows an arrangement based on CMYY, that is, includes main pixels and corner pixels representing yellow Y, magenta M, cyan C, and yellow Y.

In the description below, for illustrative purposes, the pixel arrangement of the image sensor is described with reference to the example of FIG. 2, but it should be noted that the description may apply to the pixel arrangement that is modified to the examples shown in FIGS. 3A to 3C.

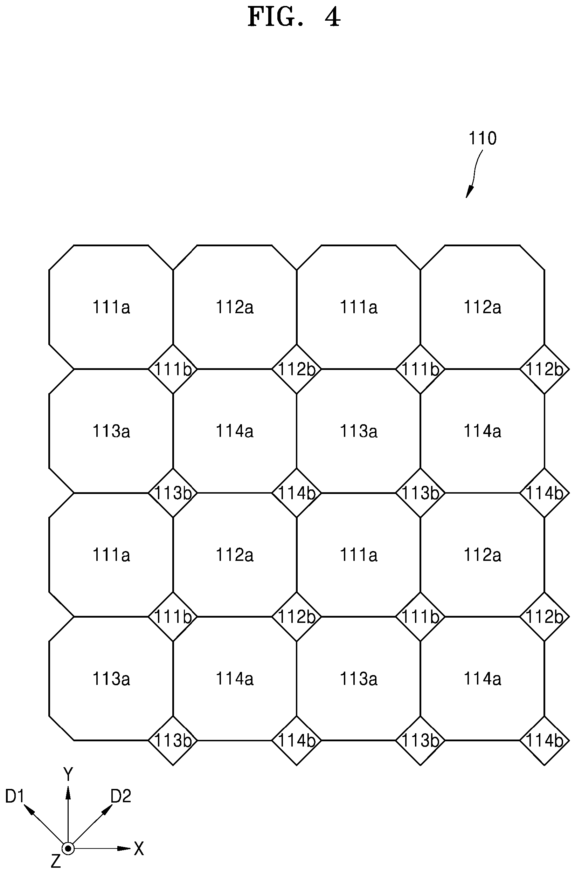

FIG. 4 is a plan view showing an arrangement of a plurality of photosensitive elements of a sensor substrate provided in a pixel array of an image sensor according to an embodiment.

A sensor substrate 110 may include a plurality of photosensitive elements configured to sense (or detect) incident light. The sensor substrate 110 may include first main photosensitive elements 111a and first corner photosensitive elements 111b that are adjacent to each other, generate light of the same wavelength, and have different sizes.

The sensor substrate 110 may include a plurality of first main photosensitive elements 111a, a plurality of second main photosensitive elements 112a, a plurality of third main photosensitive elements 113a, and a plurality of fourth main photosensitive elements 114a. The sensor substrate 110 may also include a plurality of first corner photosensitive elements 111b, a plurality of second corner photosensitive elements 112b, a plurality of third corner photosensitive elements 113b, and a plurality of fourth corner photosensitive elements 114b.

Referring to FIG. 4 along with FIG. 2, the first main photosensitive element 111a may correspond to the first green main pixel G1a, the first corner photosensitive element 111b may correspond to the first green corner pixel G1b, the second main photosensitive element 112a may correspond to the red main pixel Ra, the second corner photosensitive element 112b may correspond to the red corner pixel Rb, the third main photosensitive element 113a may correspond to the blue main pixel Ba, the third corner photosensitive element 113b may correspond to the blue corner pixel Bb, the fourth main photosensitive element 114a may correspond to the second green main pixel G2a, and the fourth corner photosensitive element 114b may correspond to the second green corner pixel G2b. Therefore, descriptions about the arrangement of the first green main pixel G1a, the first green corner pixel G1b, the red main pixel Ra, the red corner pixel Rb, the blue main pixel Ba, the blue corner pixel Bb, the second green main pixel G2a, and the second green corner pixel G2b provided above may be applied as is to the first main photosensitive element 111a, the first comer photosensitive element 111b, the second main photosensitive element 112a, the second corner photosensitive element 112b, the third main photosensitive element 113a, the third corner photosensitive element 113b, the fourth main photosensitive element 114a, and the fourth corner photosensitive element 114b.

The sensor substrate 110 may include a plurality of unit structures that are two-dimensionally arranged in the first direction and the second direction, and each of the plurality of unit structures may include the first main photosensitive element 111a, the second main photosensitive element 112a, the third main photosensitive element 113a, and the fourth main photosensitive element 114a arranged in a 2x2 array. Each of the plurality of unit structures may include the first corner photosensitive element 111b arranged to be in contact with the first main photosensitive element 111a in the first diagonal direction D1, the second corner photosensitive element 112b arranged to be in contact with the second main photosensitive element 112a in the first diagonal direction D1, the third corner photosensitive element 113b arranged to be in contact with the third main photosensitive element 113a in the first diagonal direction D1, and the fourth corner photosensitive element 114b arranged to be in contact with the fourth main photosensitive element 114a in the first diagonal direction D1. A size (e.g., width or length of one side) of the first main photosensitive element 111a may be greater than a size of the first corner photosensitive element 111b, a size of the second main photosensitive element 112a may be greater than a size of the second corner photosensitive element 112b, a size of the third main photosensitive element 113a may be greater than a size of the third corner photosensitive element 113b, and a size of the fourth main photosensitive element 114a may be greater than a size of the fourth corner photosensitive element 114b.

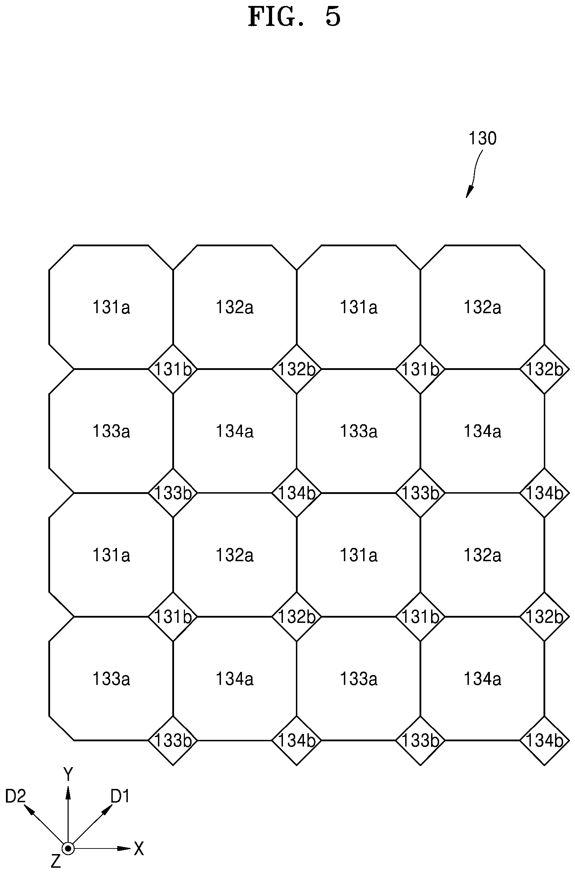

FIG. 5 is a plan view showing division of regions a nano-optical lens array provided in a pixel array of an image sensor according to an embodiment.

A nano-optical lens array 130 may be configured to color-separate incident light. For example, the nano-optical lens array 130 may separate, from the incident light, light of a first wavelength band (e.g., green light), light of a second wavelength band (e.g., red light) that is different from the first wavelength band, and light of a third wavelength band (e.g., blue light) that is different from the first and second wavelength bands and allow respective separated light to proceed in different passages. The nano-optical lens array 130 may act as a lens configured to condense light of the first wavelength band, light of the second wavelength band, and light of the third wavelength band that are color-separated onto photosensitive elements corresponding to respective light.

Referring to FIG. 5 along with FIG. 4, the nano-optical lens array 130 may include a plurality of meta-regions respectively corresponding to the plurality of photosensitive elements of the sensor substrate 110. For example, the nano-optical lens array 130 may include a plurality of first main meta-regions 131a corresponding to the plurality of first main photosensitive elements 111a, a plurality of first corner meta-regions 131b corresponding to the plurality of first corner photosensitive elements 111b, a plurality of second main meta-regions 132a corresponding to the plurality of second main photosensitive elements 112a, a plurality of second corner meta-regions 132b corresponding to the plurality of second corner photosensitive elements 112b, a plurality of third main meta-regions 133a corresponding to the plurality of third main photosensitive elements 113a, a plurality of third corner meta-regions 133b corresponding to the plurality of third corner photosensitive elements 113b, a plurality of fourth main meta-regions 134a corresponding to the plurality of fourth main photosensitive elements 114a, and a plurality of fourth corner meta-regions 134b corresponding to the plurality of fourth corner photosensitive elements 114b.

One first main meta-region 131a, one first corner meta-region 131b, one second main meta-region 132a, one second corner meta-region 132b, one third main meta-region 133a, one third corner meta-region 133b, one fourth main meta-region 134a, and one fourth corner meta-region 134b that are grouped and arranged may form one unit meta-structure. The first main meta-region 131a, the first corner meta-region 131b, the second main meta-region 132a, the second corner meta-region 132b, the third main meta-region 133a, the third corner meta-region 133b, the fourth main meta-region 134a, and the fourth corner meta-region 134b may be arranged to respectively face the first main photosensitive element 111a, the first corner photosensitive element 111b, the second main photosensitive element 112a, the second corner photosensitive element 112b, the third main photosensitive element 113a, the third corner photosensitive element 113b, the fourth main photosensitive element 114a, and the fourth corner photosensitive element 114b, respectively corresponding thereto in a third direction (Z-direction) perpendicular to the first and second directions.

That is, in the unit meta-structure, the arrangement (or positions) of the first main meta-region 131a, the first corner meta-region 131b, the second main meta-region 132a, the second corner meta-region 132b, the third main meta-region 133a, the third corner meta-region 133b, the fourth main meta-region 134a, and the fourth corner meta-region 134b may be the same as the arrangement (or positions) of the first main photosensitive element 111a, the first corner photosensitive element 111b, the second main photosensitive element 112a, the second corner photosensitive element 112b, the third main photosensitive element 113a, the third corner photosensitive element 113b, the fourth main photosensitive element 114a, and the fourth corner photosensitive element 114b, respectively corresponding thereto in the unit pixel pattern. A size (e.g., width or length of one side) of the first main meta-region 131a may be greater than a size of the first corner meta-region 131b, a size of the second main meta-region 132a may be greater than a size of the second corner meta-region 132b, a size of the third main meta-region 133a may be greater than a size of the third corner meta-region 133b, and a size of the fourth main meta-region 134a may be greater than a size of the fourth corner meta-region 134b.

The first main meta-region 131a, the first corner meta-region 131b, the second main meta-region 132a, the second corner meta-region 132b, the third main meta-region 133a, the third corner meta-region 133b, the fourth main meta-region 134a, and the fourth corner meta-region 134b included in the nano-optical lens array 130 may be configured to separate and condense, from the incident light, the light of the first wavelength band onto the first main photosensitive element 111a, the first corner photosensitive element 111b, the fourth main photosensitive element 114a, and the fourth corner photosensitive element 114b, and separate and condense the light of the second wavelength band onto the second main photosensitive element 112a and the second corner photosensitive element 112b, and separate and condense the light of the third wavelength band onto the third main photosensitive element 113a and the third corner photosensitive element 113b.

To this end, the nano-optical lens array 130 may include a plurality of nano-structures arranged according to a certain rule. The plurality of nano-structures may be separately arranged in the first main meta-region 131a, the first corner meta-region 131b, the second main meta-region 132a, the second corner meta-region 132b, the third main meta-region 133a, the third corner meta-region 133b, the fourth main meta-region 134a, and the fourth corner meta-region 134b included in the nano-optical lens array 130.

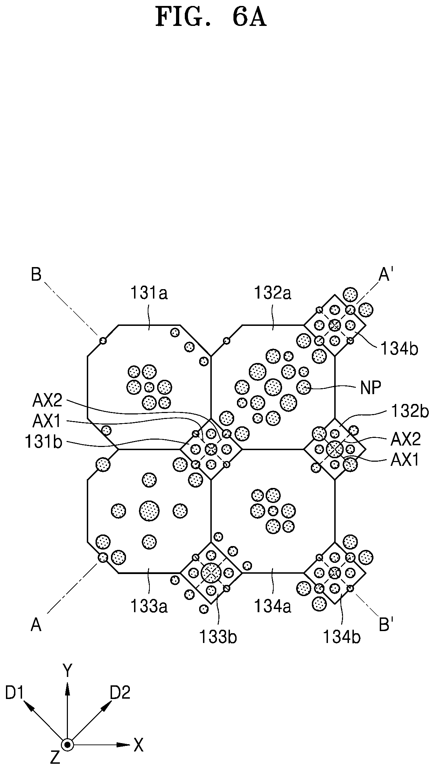

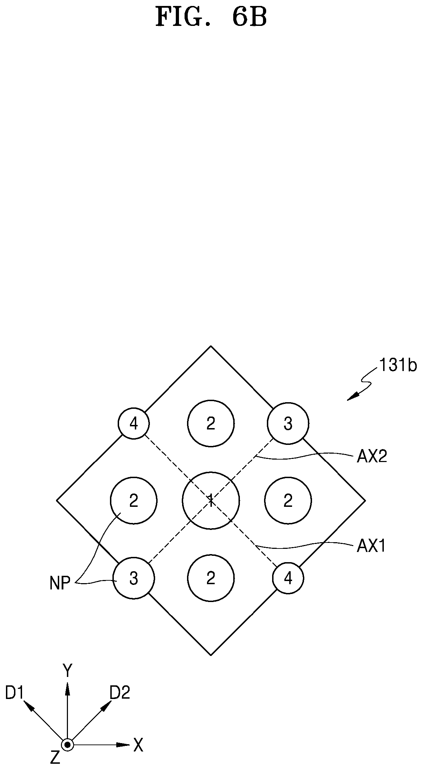

FIG. 6A is a plan view showing an example of an arrangement of nano-structures included in a nano-optical lens array provided in a pixel array of an image sensor according to an embodiment, and FIG. 6B is a plan view showing the arrangement of nano-structures in a corner meta-region of FIG. 6A.

Referring to FIGS. 6A and 6B, each of the first main meta-region 131a, the second main meta-region 132a, the third main meta-region 133a, and the fourth main meta-region 134a may include one or more nano-structures NP. The first corner meta-region 131b, the second corner meta-region 132b, the third corner meta-region 133b, and the fourth corner meta-region 134b may each include one or more nano-structures NP.

A number of nano-structures NP arranged in the first main meta-region 131a may be greater than a number of the nano-structures NP arranged in the first corner meta-region 131b. Likewise, a number of nano-structures NP arranged in each of the second main meta-region 132a, the third main meta-region 133a, and the fourth main meta-region 134a may be greater than that of the nano-structures NP arranged in each of the second corner meta-region 132b, the third corner meta-region 133b, and the fourth corner meta-region 134b. However, one or more embodiments are not limited thereto.

The nano-structures NP arranged in the first corner meta-region 131b may have symmetry based on a first axis AX1 and a second axis AX2 as symmetrical axes. The first axis AX1 may be an axis passing through a center of the first corner meta-region 131b and in parallel with the first diagonal direction D1, and the second axis AX2 may be an axis passing through the center of the first corner meta-region 131b and in parallel with the second diagonal direction D2.

The nano-structures NP in the first corner meta-region 131b may be arranged such that a size distribution (or a distribution of sizes of nano-structures NP) on the first axis AX1 is different from a size distribution on the second axis AX2. As shown in detail in FIG. 6B, the nano-structures NP having different sizes may be arranged in the first corner meta-region 131b. The nano-structures NP having the same size are indicated by the same number, and the size distribution on the first axis AX1 and the size distribution on the second axis AX2 may be different from each other.

In FIGS. 6A and 6B, a number of nano-structures NP located on the first axis AX1 and a number of nano-structures NP located on the second axis AX2 may be equal to each other in the first corner meta-region 131b, but are not limited thereto. The number of nano-structures NP located on the first axis AX1 and the number of nano-structures NP located on the second axis AX2 in the first corner meta-region 131b may be different from each other. Similarly to the first corner meta-region 131b shown in detail in FIG. 6B, the nano-structures in the second corner meta-region 132b, the third corner meta-region 133b, and the fourth corner meta-region 134b may have similar arrangement types.

In the second corner meta-region 132b, the third corner meta-region 133b, and the fourth corner meta-region 134b, the first axis AX1 that passes through the center thereof and is parallel to the first diagonal direction D1 and the second axis AX2 that passes through the center thereof and is parallel to the second diagonal direction may be defined.

The nano-structures NP arranged in the second corner meta-region 132b may have symmetry based on the first axis AX1 and the second axis AX2 of the second corner meta-region 132b as symmetric axes. The nano-structures NP arranged in the second corner meta-region 132b may be arranged such that a size distribution on the first axis AX1 is different from a size distribution on the second axis AX2.

In the second corner meta-region 132b, a number of the nano-structures NP located on the first axis AX1 and a number of nano-structures NP located on the second axis AX2 may be different from each other, but are not limited thereto, that is, may be equal to each other.

The nano-structures NP arranged in the third corner meta-region 133b may have symmetry based on the first axis AX1 and the second axis AX2 of the third corner meta-region 133b as symmetric axes. The nano-structures NP arranged in the third corner meta-region 133b may be arranged such that a size distribution on the first axis AX1 is different from a size distribution on the second axis AX2.

In the third corner meta-region 133b, a number of the nano-structures NP located on the first axis AX1 and a number of nano-structures NP located on the second axis AX2 may be different from each other, but are not limited thereto, that is, may be equal to each other.

The nano-structures NP arranged in the fourth corner meta-region 134b may have symmetry based on the first axis AX1 and the second axis AX2 of the fourth corner meta-region 134b as symmetric axes. The nano-structures NP arranged in the fourth corner meta-region 134b may be arranged such that a size distribution on the first axis AX1 is different from a size distribution on the second axis AX2.

As shown in FIG. 6A, the nano-structures NP arranged in the first corner meta-region 131b and the nano-structures NP arranged in the fourth corner meta-region 134b may have the same arrangement type. However, one or more embodiments are not limited to the above example. The arrangement types of the nano-structures NP in the first corner meta-region 131b and the fourth corner meta-region 134b may be in a 180° angle rotational symmetric relationship.

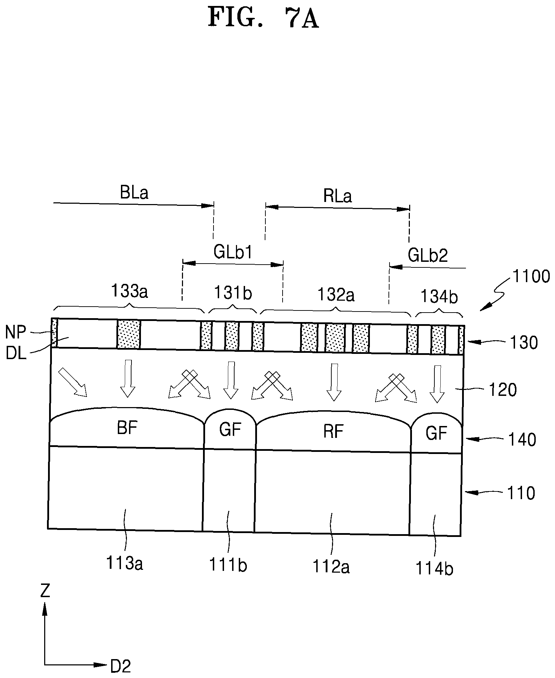

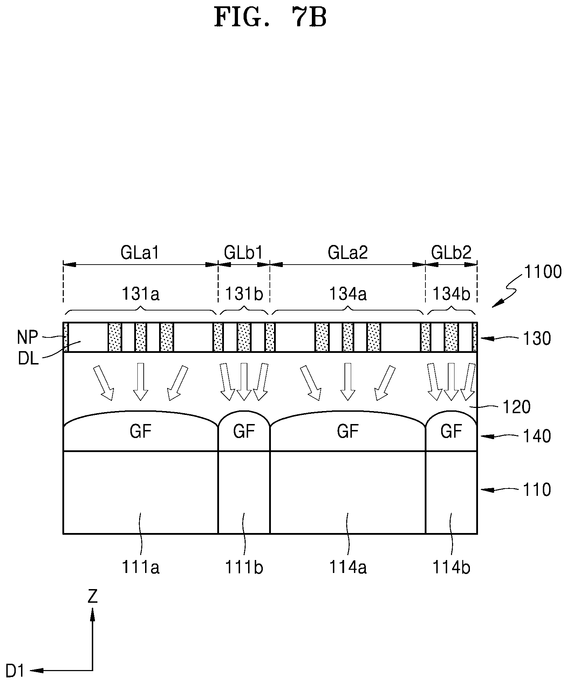

FIGS. 7A and 7B are cross-sectional views of a pixel array in the image sensor taken along lines A-A' and B-B' of FIG. 6A, respectively.

Referring to FIGS. 7A and 7B, the pixel array 1100 may include the sensor substrate 110, and the nano-optical lens array 130 arranged above the sensor substrate 110. A spacer layer 120 may be disposed between the sensor substrate 110 and the nano-optical lens array 130. A color filter layer 140 may be disposed between the sensor substrate 110 and the spacer layer 120. The color filter layer 140 may be omitted depending on embodiments.

As described above in detail with reference to FIG. 4, the sensor substrate 110 may include the first main photosensitive element 111a, the second main photosensitive element 112a, the third main photosensitive element 113a, and the fourth main photosensitive element 114a, and may further include the first corner photosensitive element 111b, the second corner photosensitive element 112b, the third corner photosensitive element 113b, and the fourth corner photosensitive element 114b. FIGS. 7A and 7B show cross-sections respectively taken alone line A-A' and B-B' of FIG. 6A, and the second corner photosensitive element 112b and the third corner photosensitive element 113b are not shown.

The spacer layer 120 may be disposed between the sensor substrate 110 and the nano-optical lens array 130 in order to maintain a constant distance between the sensor substrate 110 and the nano-optical lens array 130. The spacer layer 120 may include a transparent material for visible ray, for example, a dielectric material having a lower refractive index than that of nano-structures NP that are described later and low absorption rate in a visible ray band, e.g., poly methylmethacrylate (PMMA), siloxane-based spin on glass (SOG), SiO₂, SiN4, Al₂O₃, etc.

The color filter layer 140 may include a plurality of color filters each configured to transmit light of a certain wavelength band and absorb light of different wavelength bands. For example, the color filter layer 140 may include a red color filter GF configured to transmit green light and absorb light of another wavelength, a red color filter RF configured to transmit the red light and absorb light of another wavelength band, and a blue color filter BF configured to transmit the blue light and absorb the light of another wavelength band.

The green color filter GF may be disposed on the first main photosensitive element 111a, the first corner photosensitive element 111b, the fourth main photosensitive element 114a, and the fourth corner photosensitive element 114b, the red color filter RF may be disposed on the second main photosensitive element 112a and the second corner photosensitive element 112b, and the blue color filter BF may be disposed on the third main photosensitive element 113a and the third corner photosensitive element 113b. Because the incident light is color-separated by the nano-optical lens array 130 to a considerable degree, an absorption loss that may occur in the color filter layer 140 (e.g., loss of light due to absorption of light by the color filter layer 140) may be low even when the color filter layer 140 is used. Also, color purity may be improved by using the nano-optical lens array 130 and the color filter layer 140 together.

The nano-optical lens array 130 may include the plurality of nano-structures NP and may further include a dielectric layer DL that fills a space between the plurality of nano-structures NP. In order for the nano-optical lens array 130 to perform the functions of color separation and light condensing described above, the plurality of nano-structures NP of the nano-optical lens array 130 may be variously configured. For example, the plurality of nano-structures NP may be arranged such that a phase of light transmitting through the nano-optical lens array 140 is changed according to a position on the nano-optical lens array 130. A phase profile of the transmitted light, which is implemented by the nano-optical lens array 130, may be determined according to a cross-sectional size (e.g., width or diameter), a cross-sectional shape, a height of each of the nano-structures NP, and/or an arrangement period (or pitch) and an arrangement type of the plurality of nano-structures NP. A behavior of the light passing through the nano-optical lens array 130 may be determined according to the phase profile of the transmitted light.

The nano-structures NP may each have a size that is less than a wavelength of visible light. The nano-structures NP may have a size that is less than, for example, a blue wavelength. For example, the cross-sectional width (or diameter) of the nano-structures NP may be less than 400 nm, 300 nm, or 200 nm, and may be greater than about 80 nm. The height of the nano-structures NP may be about 500 nm to about 1500 nm, and may be greater than the cross-sectional width of the nano-structures NP.

The nano-structures NP may include a material having a relatively higher refractive index as compared with a peripheral material and having a relatively lower absorption ratio in the visible ray band. For example, the nano-structures NP may include c-Si, p-Si, a-Si and a Group III-V compound semiconductor (GaP, GaN, GaAs etc.), SiC, TiO₂, SiN₃, ZnS, ZnSe, Si₃N₄, and/or any combination thereof. Periphery of the nano-structures NP may be filled with the dielectric layer DL having a relatively lower refractive index as compared with the nano-structures NP and have a relatively low absorbent ratio in the visible ray band. For example, the dielectric layer DL may be filled with PMMA, SOG, SiO₂, Si₃N₄, Al₂O₃, air, etc.

The refractive index of the nano-structures NP may be about 2.0 or greater with respect to light of about a 630 nm wavelength, and the refractive index of the dielectric layer DL may be about 1.0 to about 2.0 or less with respect to the light of about the 630 nm wavelength. A difference between the refractive indexes of the nano-structures NP and the refractive index of the dielectric layer DL may be about 0.5 or greater. The nano-structures NP having a difference in a refractive index from the refractive index of the peripheral material may change the phase of light that passes through the nano-structures NP. This is caused by a phase delay that occurs due to a shape dimension of the sub-wavelength of the nanostructures NP, and a degree at which the phase is delayed may be determined by a detailed shape dimension and an arrangement shape of the nanostructures NP.

Due to the arrangement of the nano-structures NP, the color separation and light condensing performed by the nano-optical lens array 130 may vary depending on the colors of photosensitive elements in the sensor substrate 110 facing the nano-optical lens array 130.

Although not shown in the drawings, an etch-stop layer may be disposed between the spacer layer 120 and the nano-optical lens array 130. The etch-stop layer may be provided to protect the spacer layer 120 that is a lower structure of the nano-optical lens array 130, during the manufacturing processes of the nano-optical lens array 130. When the nano-optical lens array 130 is manufactured on the spacer layer 120, the dielectric layer DL may be entirely formed on the spacer layer 120 and a process of etching the dielectric layer DL to a certain depth may be performed. Here, the spacer layer 120 may be damaged when the etching is performed to a thickness deeper than a desired thickness, and when the thickness of the spacer layer 120 is not suitable for a condition of a distance between the nano-optical lens array 130 and the sensor substrate 110, the color separation performance may be degraded. The etch-stop layer may include a material having a lower etch selectivity than a material layer that is to be etched, and thus, may not be removed during the etching process and remain, and accordingly, damage to the spacer layer 120 may be prevented in the etching process. The etch-stop layer may include, for example, HfO₂. A thickness of the etch-stop layer may be determined in consideration of the etched depth, that is, the height of the nano-structures NP, and may be also determined based on an etching dispersion in a processed wafer. For example, the etch-stop layer may have a thickness of about 3 nm to about 30 nm.

Although not shown in the drawings, a protective layer for protecting the nano-optical lens array 130 may be further disposed on the nano-optical lens array 130. The protective layer may include a material that may serve as an anti-reflection layer. The anti-reflection layer may reduce light reflected by an upper surface of the nano-optical lens array 130, and thus, may improve light-utilization efficiency of the pixel array 1100. In other words, the anti-reflection layer may cause the light incident on the pixel array 1100 from an outside to transmit through the nano-optical lens array 130 and to be sensed by the sensor substrate 110, without being reflected from the upper surface of the nano-optical lens array 130. The anti-reflection layer may have a structure in which one or a plurality of layers are stacked, for example, may include one layer having a material different from the material included in the anti-reflection layer 130 or a plurality of material layers having different refractive indexes.

Referring to FIG. 7A, the first corner meta-region 131b may separate green light from the light incident on the third main meta-region 133a and the second main meta-region 132a adjacent to the first corner meta-region 131b, as well as the first corner meta-region 131b, and condense the separated light onto the first corner photosensitive element 111b. The fourth corner meta-region 134b may separate the green light from the light incident on the second main meta-region 132a and the third main meta-region 133a adjacent to the fourth corner meta-region 134b, as well as the fourth corner meta-region 134b, and condense the separated light onto the fourth corner photosensitive element 114b.

The second main meta-region 132a may separate red light from the light incident on the first corner meta-region 131b and the fourth corner meta-region 134b adjacent to the second main meta-region 132a, as well as the second main meta-region 132a, and condense the separate light onto the second main photosensitive element 112a. The third main meta-region 133a may separate blue light from the light incident on the first corner meta-region 131b and the fourth corner meta-region 134b, as well as the third main meta-region 133a, and condense the separated light onto the third main photosensitive element 113a.

As described above, regions of the nano-optical lens array 130 may be described to include a main blue light condensing region BLa, a first corner green light condensing region GLb1, a main red light condensing region RLa, and a second corner green light condensing region GLb2, and the main blue light condensing region BLa, the first corner green light condensing region GLb1, the main red light condensing region RLa, and the second corner green light condensing region GLb2 may each have a width in the second diagonal direction D2, which is respectively greater than a width of a corresponding one of the third main meta-region 133a, the first corner meta-region 131b, the second main meta-region 132a, and the fourth corner meta-region 134b in the second diagonal direction D2.

Referring to FIG. 7B, the first main photosensitive element 111a, the first corner photosensitive element 111b, the fourth main photosensitive element 114a, and the fourth corner photosensitive element 114b configured to sense the green light may be arranged in the first diagonal direction D1.

Therefore, the first corner meta-region 131b may separate the green light from the light incident on the first corner meta-region 131 and condense the light onto the first corner photosensitive element 111b, and does not attract the green light from the light incident on the first main meta-region 131a and the fourth main meta-region 134a that are adjacent to the first corner meta-region 131b. The fourth corner meta-region 134b may separate the green light from the light incident on the fourth corner meta-region 134b and condense the separated light onto the fourth corner photosensitive element 114b, and does not attract the green light from the light incident on the fourth main meta-region 134a and the first main meta-region 131a that are adjacent to the fourth corner meta-region 134b.

The first main meta-region 131a may separate the green light from the light incident on the first main meta-region 131a and may condense the separated light onto the first main photosensitive element 111a, and does not attract the green light from the light incident on the first corner meta-region 131b and the fourth corner meta-region 134b that are adjacent to the first main meta-region 131a. The fourth main meta-region 134a may separate the green light from the light incident on the fourth main meta-region 134a and may condense the separated light onto the fourth main photosensitive element 114a, and does not attract the green light from the light incident on the first corner meta-region 131b and the fourth corner meta-region 134b that are adjacent to the fourth main meta-region 134a.

As described above, the regions of the nano-optical lens array 130 may be described to include the first main green light condensing region GLa1, the first comer green light condensing region GLb1, the second main green light condensing region GLa2, and the second corner green light condensing region GLb2, and the first main green light condensing region GLa1, the first corner green light condensing region GLb1, the second main green light condensing region GLa2, and the second corner green light condensing region GLb2 may each have a width in the first diagonal direction D1, which may be the same as the width of a corresponding one of the first main meta-region 131a, the first corner meta-region 131b, the second main meta-region 132a, and the second corner meta-region 132b, respectively.

However, this is an example, and in a modified embodiment, the first corner meta-region 131b and the fourth corner meta-region 134b may not attract the green light incident on the adjacent regions, but the first main meta-region 131a and the fourth main meta-region 134a may attract the green light incident on the adjacent regions. In other words, the first corner green light condensing region GLb1 and the second corner green light condensing region GLb2 may each have the width in the first diagonal direction D1, which may be the same as the width of a corresponding one of the first corner meta-region 131b and the fourth corner meta-region 134b in the first diagonal direction D1, and the first main green light condensing region GLa1 and the second main green light condensing region GLa2 may each have the width in the first diagonal direction D1, which is respectively greater than the width of the corresponding one the first main meta-region 131a and the fourth main meta-region 134a in the first diagonal direction D1.

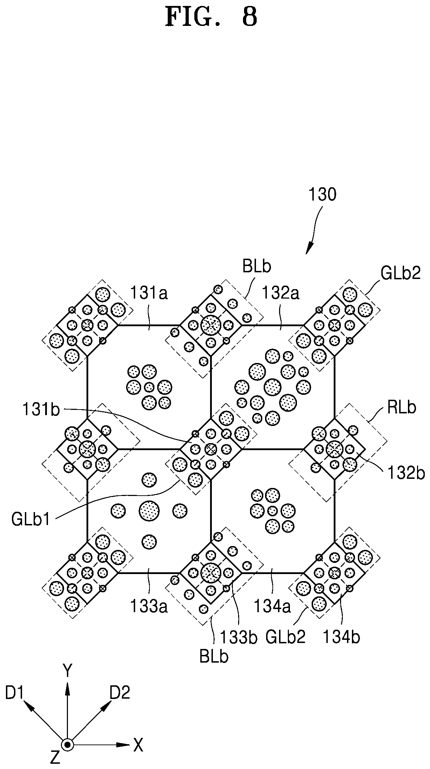

The light condensing regions included in the nano-optical lens array 130 are described in more detail below with reference to FIGS. 8 to 10C.

FIG. 8 is a plan view showing an example of corner light condensing regions included in a nano-optical lens array in a pixel array of an image sensor according to an embodiment.

Referring to FIG. 8, the nano-optical lens array 130 may include the first corner green light condensing region GLb1, the second corner green light condensing region GLb2, a corner red light condensing region RLb, and a corner blue light condensing region BLb.

The first corner green light condensing region GLb1 may condense the green light, included in incident light incident on the first corner green light condensing region GLb1, onto the first corner photosensitive element 111b. The second corner green light condensing region GLb2 may condense the green light, included in incident light incident on the second corner green light condensing region GLb2, onto the fourth corner photosensitive element 114b. The corner red light condensing region RLb may condense the red light, included in incident light incident on the corner red light condensing region RLb, onto the second corner photosensitive element 112b. The corner blue light condensing region BLb may condense the blue light, included in the incident light incident on the corner blue light condensing region BLb, onto the third corner photosensitive element 113b.

The first corner green light condensing region GLb1, the second corner green light condensing region GLb2, the corner red light condensing region RLb, and the corner blue light condensing region BLb may each have different widths in the first diagonal direction D1 and the second diagonal direction D2. The widths in the first diagonal direction D1 and the second diagonal direction D2 of each region may be determined according to whether adjacent regions thereof face pixels of the same color.

The first corner green light condensing region GLb1, the second corner green light condensing region GLb2, the corner red light condensing region RLb, and the corner blue light condensing region BLb may each have the width in the second diagonal direction D2, which is greater than or equal to that in the first diagonal direction D1.

In the first corner green light condensing region GLb1, the second corner green light condensing region GLb2, the corner red light condensing region RLb, and the corner blue light condensing region BLb, as shown in FIGS. 6A and 6B, the first axis and the second axis may be defined, and the nano-structures in each of the first corner green light condensing region GLb1, the second corner green light condensing region GLb2, the corner red light condensing region RLb, and the corner blue light condensing region BLb may have a size distribution on the first axis, which is different from that on the second axis.

The width in each of the first corner green light condensing region GLb1 and the second corner green light condensing region GLb2 in the first diagonal direction D1 may be equal to the width of the first corner meta-region 131b and the fourth corner meta-region 134b in the first diagonal direction D1. The width in each of the first corner green light condensing region GLb1 and the second corner green light condensing region GLb2 in the second diagonal direction D2 may be greater than the width of the first corner meta-region 131b and the fourth corner meta-region 134b in the second diagonal direction D2.

The corner red light condensing region RLb may have the width in the first diagonal direction D1, which is greater than that of the second corner meta-region 132b in the first diagonal direction D1, and the width in the second diagonal direction D2, which is greater than the width of the second corner meta-region 132b in the second diagonal direction D2. The second corner meta-region 132b may have the width in the first diagonal direction D1 less than the width thereof in the second diagonal direction D2. This is because the second corner meta-region 132b may come into contact with the second main meta-region 132a in the first diagonal direction D1, and the second corner meta-region 132b and the second main meta-region 132a face pixels of the same red color.

The corner blue light condensing region BLb may have the width in the first diagonal direction D1, which is greater than that of the third corner meta-region 133b in the first diagonal direction D1, and the width in the second diagonal direction D2, which is greater than that of the third corner meta-region 133b in the second diagonal direction D2. The corner blue light condensing region BLb may have the width in the first diagonal direction D1, which is less than the width thereof in the second diagonal direction D2. The third corner meta-region 133b may be in contact with the third main meta-region 133a in the first diagonal direction D1, and the third corner meta-region 133b and the third main meta-region 133a may each face pixels of the same blue color.

In FIG. 8, sizes of the corner red light condensing region RLb and the corner blue light condensing region BLb, that is, areas of cross-sections cut along the first direction (X-direction) and the second direction (Y-direction) (or areas on a plane defined by the first direction and the second direction), are shown to be greater than sizes of the first corner green light condensing region GLb1 and the second corner green light condensing region GLb2, but are not limited thereto. According to the width in the second diagonal direction D2, the sizes of the first corner green light condensing region GLb1 and the second corner green light condensing region GLb2 may be greater than those of the corner red light condensing region RLb or the corner blue light condensing region BLb.

In FIG. 8, the first corner green light condensing region GLb1, the corner red light condensing region RLb, the corner blue light condensing region BLb, and the second corner green light condensing region GLb2 are each shown to have the size greater than the size of a corresponding one of the first corner meta-region 131b, the second corner meta-region 132b, the third corner meta-region 133b, and the fourth corner meta-region 134b, but these are example and are not limited thereto. When the width of each of the first corner green light condensing region GLb1, the corner red light condensing region RLb, the corner blue light condensing region BLb, and the second corner green light condensing region GLb2 in the second diagonal direction D2 is less than the width of a corresponding one of the first corner meta-region 131b, the second corner meta-region 132b, the third corner meta-region 133b, and the fourth corner meta-region 134b in the second diagonal direction D2, the first corner green light condensing region GLb1, the corner red light condensing region RLb, the corner blue light condensing region BLb, and the second corner green light condensing region GLb2 may have the sizes that are respectively less than sizes of the corresponding one of the first corner meta-region 131b, the second corner meta-region 132b, the third corner meta-region 133b, and the fourth corner meta-region 134b.

The size of the first corner green light condensing region GLb1 may be about equal to or less than three times of the size of the first corner meta-region 131b. The size of the first corner green light condensing region GLb1 may be about equal to or greater than 1/4 of the size of the first corner meta-region 131b.

The size of the second corner green light condensing region GLb2 may be about equal to or less than three times of the fourth corner meta-region 134b. The size of the second corner green light condensing region GLb2 may be equal to or less than half the size of the fourth corner meta-region 134b.

The sizes of the corner red light condensing region RLb and the corner blue light condensing region BLb may be respectively about equal to or greater than 1/2 of the sizes of the second corner meta-region 132b and the third corner meta-region 133b, and equal to or less than three times of the sizes of the second corner meta-region 132b and the third corner meta-region 133b.

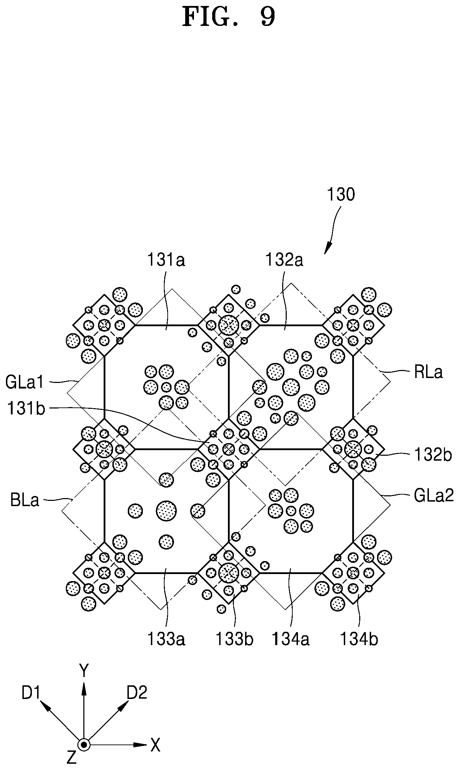

FIG. 9 is a plan view showing an example of main light-condensing regions included in a nano-optical lens array in a pixel array of an image sensor according to an embodiment.

Referring to FIG. 9, the nano-optical lens array 130 may include the first main green light condensing region GLa1, the second main green light condensing region GLa2, the main red light condensing region RLa, and the main blue light condensing region BLa.

The first main green light condensing region GLa1 may condense the green light, in the incident light incident thereon, onto the first main photosensitive element 111a. The second main green light condensing region GLa2 may condense the green light, in the incident light incident thereon, onto the fourth main photosensitive element 114a. The main red light condensing region RLa may condense the red light, in the incident light incident thereon, onto the second main photosensitive element 112a. The main blue light condensing region BLa may condense the blue light, in the incident light incident thereon, onto the third main photosensitive element 113a.

The first main green light condensing region GLa1, the second main green light condensing region GLa2, the main red light condensing region RLa, and the main blue light condensing region BLa may each have different widths in the first diagonal direction D1 and in the second diagonal direction D2. The widths in the first diagonal direction D1 and the second diagonal direction D2 of each region may be determined according to whether adjacent regions thereof face pixels of the same color.

The first main green light condensing region GLa1, the second main green light condensing region GLa2, the main red light condensing region RLa, and the main blue light condensing region BLa may each have the width in the second diagonal direction D2, which is greater than or equal to the width thereof in the first diagonal direction D1. The first main green light condensing region GLa1, the second main green light condensing region GLa2, the main red light condensing region RLa, and the main blue light condensing region BLa may each have the width in the second diagonal direction D2, which is greater than the width thereof in the first diagonal direction D1.

The widths of the first main green light condensing region GLa1 and the second main green light condensing region GLa2 in the first diagonal direction D1 may be respectively equal to the widths of the first main meta-region 131a and the fourth main meta-region 134a in the first diagonal direction D1. The widths of the first main green light condensing region GLa1 and the second main green light condensing region GLa2 in the second diagonal direction D2 may be respectively greater than or equal to the widths of the first main meta-region 131a and the fourth main meta-region 134a in the second diagonal direction D2.

The width of the main red light condensing region RLa in the first diagonal direction D1 may be greater than the width of the second main meta-region 132a in the first diagonal direction D1, and the width of the main red light condensing region RLa in the second diagonal direction D2 may be greater than the width of the second main meta-region 132a in the second diagonal direction D2. The main red light condensing region RLa may have a width in the first diagonal direction D1 less than a width thereof in the second diagonal direction D2. The second main meta-region 132a may come into contact with the second corner meta-region 132b in the first diagonal direction D1, and the second main meta-region 132a and the second corner meta-region 132b face the pixels of the same red color.

The width of the main blue light condensing region BLa in the first diagonal direction D1 may be greater than the width of the third main meta-region 133a in the first diagonal direction D1, and the width of the main blue light condensing region BLa in the second diagonal direction D2 may be greater than the width of the third main meta-region 133a in the second diagonal direction D2. The main blue light condensing region BLa may have a width in the first diagonal direction D1 less than a width thereof in the second diagonal direction D2. The third main meta-region 133a may be in contact with the third corner meta-region 133b in the first diagonal direction D1, and the third main meta-region 133a and the third corner meta-region 133b face the pixels of the same blue color.

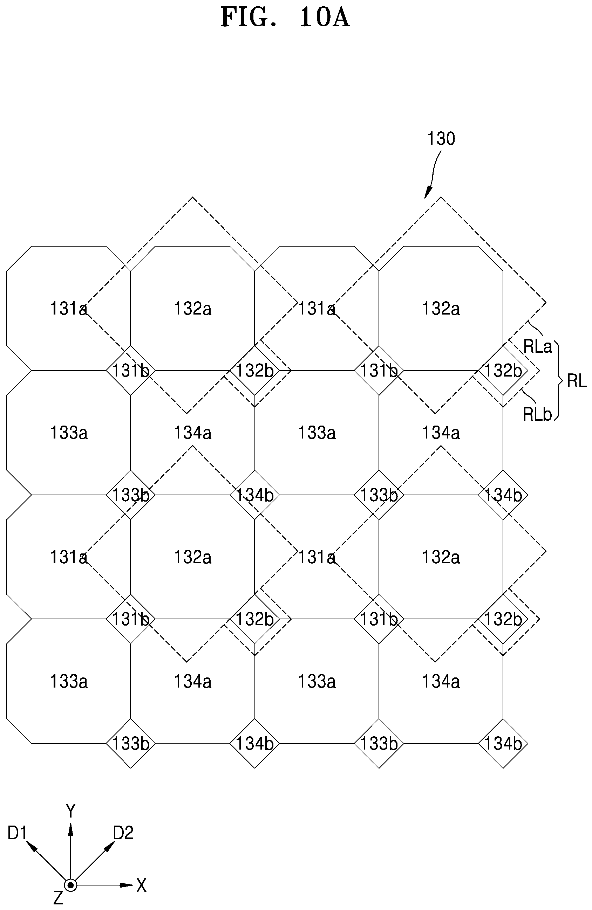

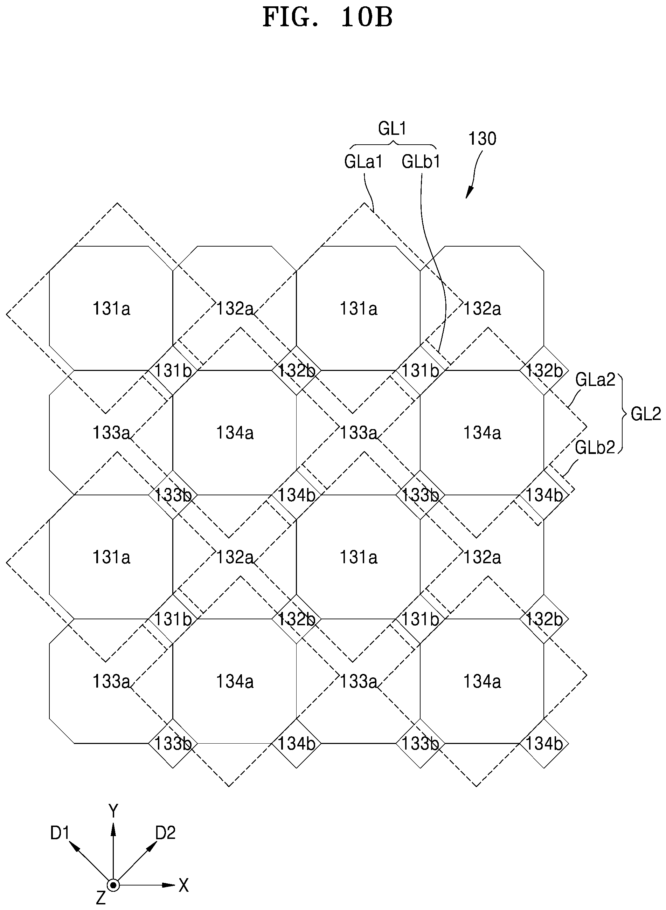

FIGS. 10A and 10B are plan views showing examples of red light condensing regions, green light condensing regions, and blue light condensing regions included in a nano-optical lens array in a pixel array of an image sensor according to an embodiment.

Referring to FIG. 10A, the red light condensing region RL may include the main red light condensing region RLa and the corner red light condensing region RLb. Sizes of the main red light condensing region RLa and the corner red light condensing region RLb may be as those described above with reference to FIGS. 8 and 9. The nano-optical lens array 130 may include an array of the red light condensing regions RL for condensing the red light, in the incident light, onto the red pixels.

Referring to FIG. 10B, first green light condensing regions GL1 and second green light condensing regions GL2 are shown. The first green light condensing region GL1 may include the first main green light condensing region GLa1 and the first corner green light condensing region GLb1. The second green light condensing region GL2 may include the second main green light condensing region GLa2 and the second corner green light condensing region GLb2. The sizes of the first main green light condensing region GLa1, the first corner green light condensing region GLb1, the second main green light condensing region GLa2, and the second corner green light condensing region GLb2 may be as those described above with reference to FIGS. 8 and 9. The nano-optical lens array 130 may include an array of the green light condensing regions GL1 and GL2 configured to condense the green light, in the incident light, onto the pixels.

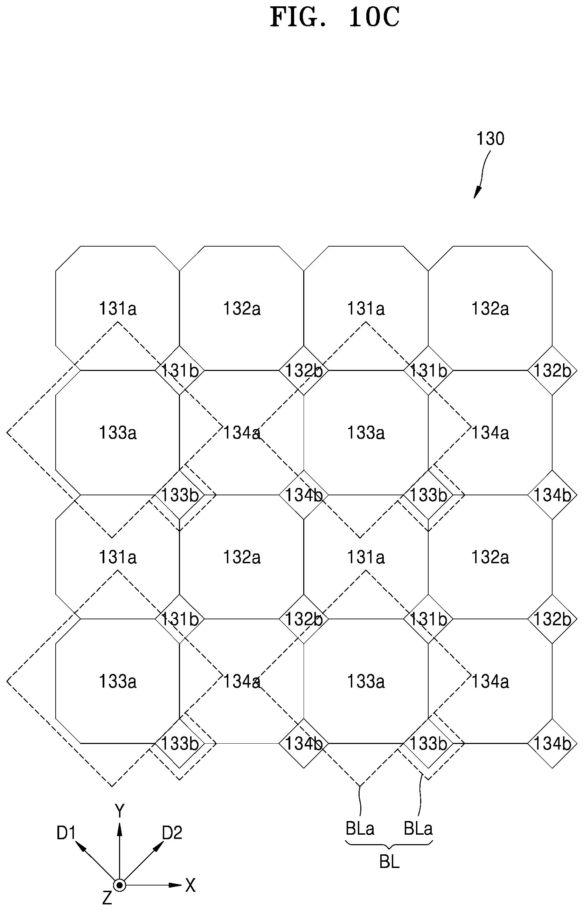

Referring to FIG. 10C, the blue light condensing region BL may include the main blue light condensing region BLa and the corner blue light condensing region BLb. Sizes of the main blue light condensing region BLa and the corner blue light condensing region BLb may be as those described above with reference to FIGS. 8 and 9. The nano-optical lens array 130 may include an array of the blue light condensing regions BL configured to condense the blue light, in the incident light, onto the blue pixels.

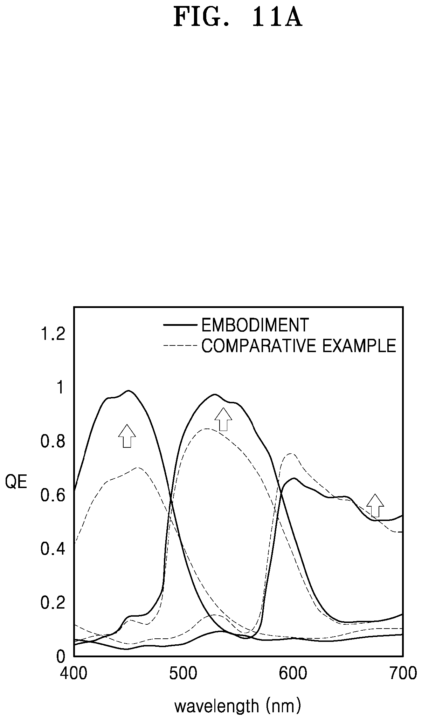

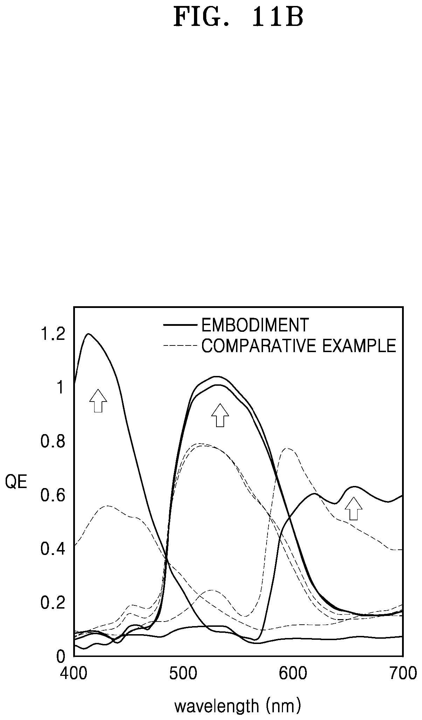

FIGS. 11A and 11B are graphs showing color-separating performance of the image sensor according to the embodiment as compared with a comparative example.

FIG. 11A shows spectrums of light sensed by main pixels, that is, the first main photosensitive element 111a, the second main photosensitive element 112a, the third main photosensitive element 113a, and the fourth main photosensitive element 114a, and FIG. 11B shows spectrums of light sensed by corner pixels, that is, the first corner photosensitive element 111b, the second corner photosensitive element 112b, the third corner photosensitive element 113b, and the fourth corner photosensitive element 114b.

The comparative example denotes an example in which the arrangement of nano-structures forming the light condensing regions as in the example embodiment are not applied. As shown in the graphs of FIGS. 11A and 11B, in the embodiment, the optical efficiency is improved as compared with the comparative example.

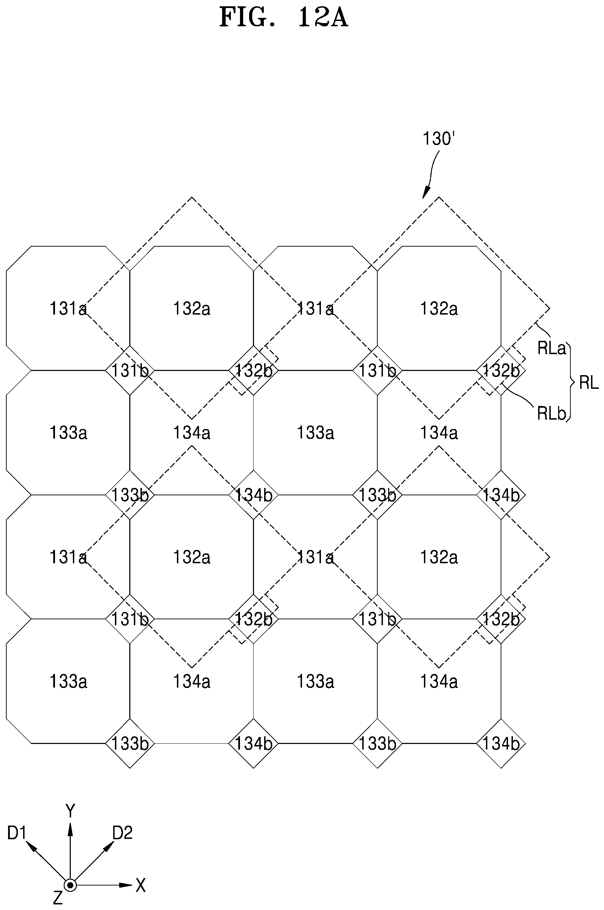

FIGS. 12A to 12C are plan views showing other examples of red light condensing regions, green light condensing regions, and blue light condensing regions included in a nano-optical lens array according to another embodiment.

Referring to FIG. 12A, a nano-optical lens array 130' according to the embodiment may be different from the nano-optical lens array described above with reference to FIG. 10A in that the width of the corner red light condensing region RLb in the first diagonal direction D1 is reduced and the width of the main red light condensing region RLa in the first diagonal direction D1 is increased.

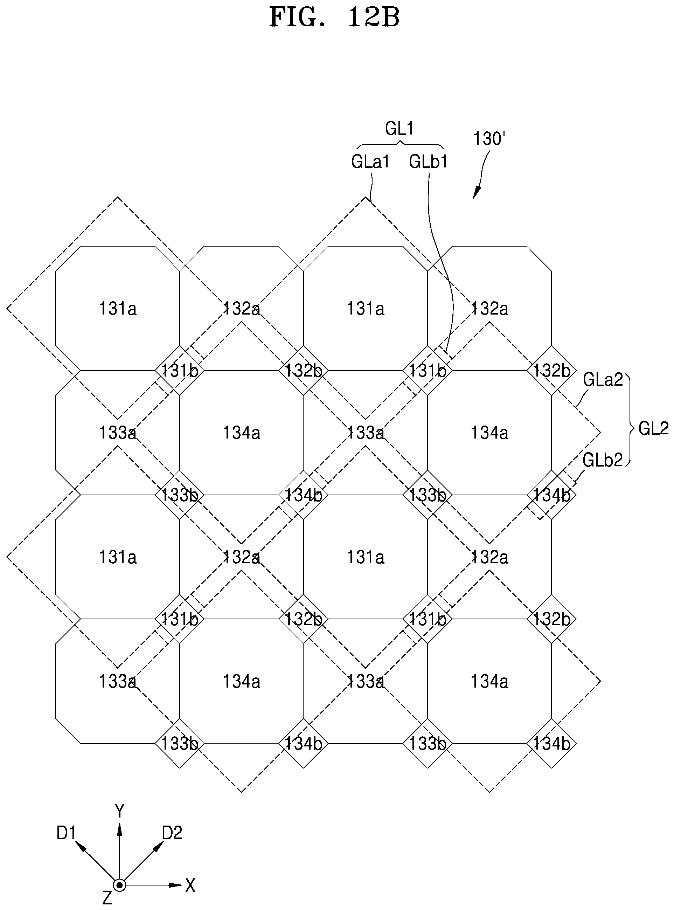

Referring to FIG. 12B, the nano-optical lens array 130' may be different from the nano-optical lens array described above with reference to FIG. 10A in that the widths of the first corner green light condensing region GLb1 and the second corner green light condensing region GLb2 in the first diagonal direction D1 are reduced and the widths of the first main green light condensing region GLa1 and the second main green light condensing region GLa2 in the first diagonal direction D1 are increased.

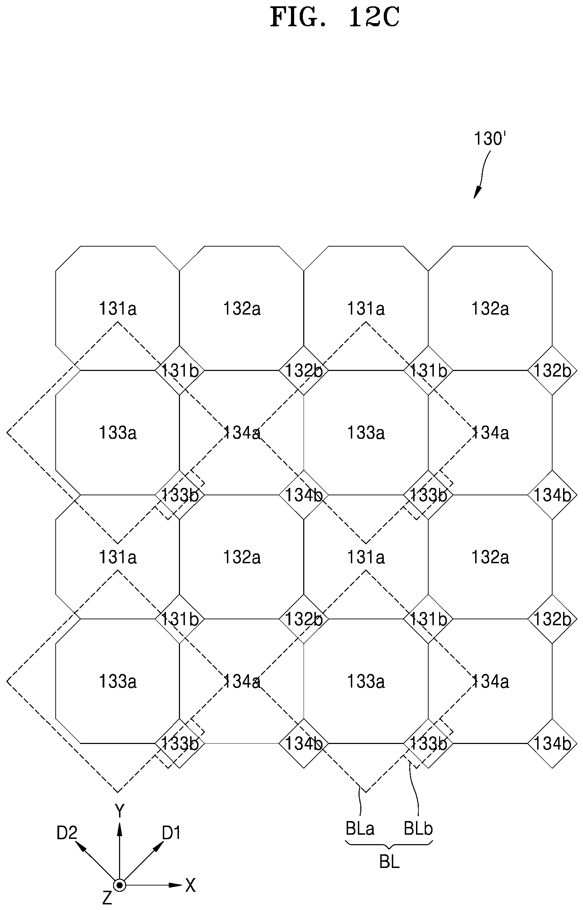

Referring to FIG. 12C, the nano-optical lens array 130' of the embodiment may be different from the nano-optical lens array described above with reference to FIG. 10C in that the width of the corner blue light condensing region BLb in the first diagonal direction D1 is reduced and the width of the main blue light condensing region BLa in the first diagonal direction D1 is increased.

Hereinafter, various examples of arranging the nano-structures in the nano-optical lens array forming the above condensing regions as described above are described below.

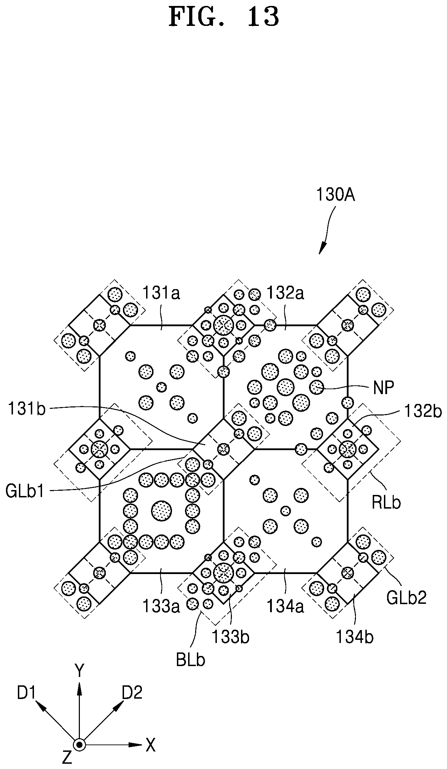

FIG. 13 is a plan view showing an example of an arrangement of a plurality of nano-structures in a nano-optical lens array 130A according to another embodiment.

Referring to FIG. 13, corner light condensing regions formed in the nano-optical lens array 130A may be greater than the corner condensing regions formed in the nano-optical lens array 130 of FIG. 8. For example, the width of the first corner green light condensing region GLb1 in the second diagonal direction D2 may be greater than the width of the first corner green light condensing region GLb1 in the second diagonal direction in the nano-optical lens array 130 of FIG. 8. The widths of the corner red light condensing region RLb and the corner blue light condensing region BLb in the first diagonal direction D1 may be greater than the widths of the corner blue light condensing region BLb and the corner red light condensing region RLb in the first diagonal direction D1 in the nano-optical lens array 130 of FIG. 8.

The number of nano-structures NP located on the first axis AX1 and the number of nano-structures NP located on the second axis AX2 may be different from each other in the first corner meta-region 131b. The number of nano-structures NP arranged on the first axis AX1 in the fourth corner meta-region 134b may be different from the number of nano-structures NP arranged on the second axis AX2.

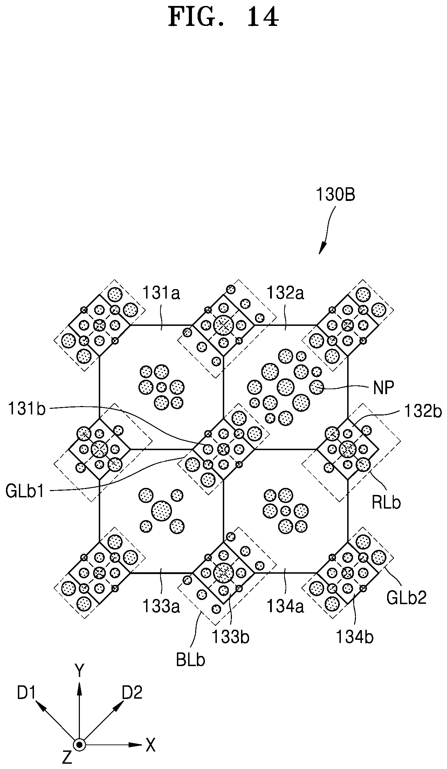

FIG. 14 is a plan view showing an example of an arrangement of a plurality of nano-structures in a nano-optical lens array 130B according to another embodiment.

The nano-optical lens array 130B of FIG. 14 may be similar to the nano-optical lens array 130 of FIG. 8 in view of the sizes of the condensing regions and may be different from the nano-optical lens array 130 of FIG. 8 in view of the number or arrangement of the nano-structures.

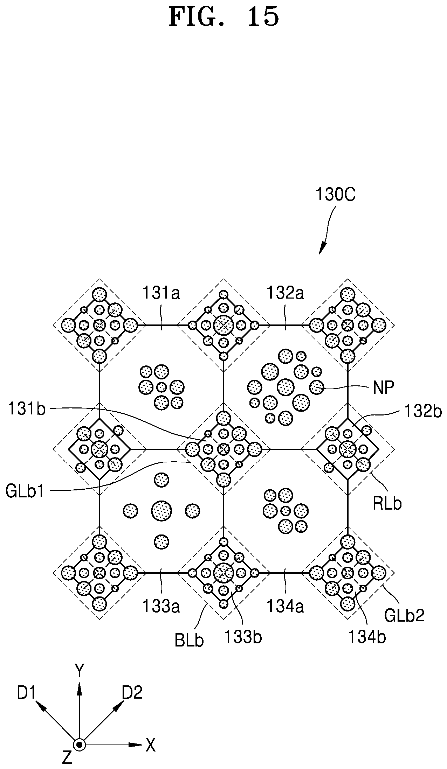

FIG. 15 is a plan view showing an example of an arrangement of a plurality of nano-structures in a nano-optical lens array 130C according to another embodiment.

The nano-optical lens array 130C of the embodiment may be different from the nano-optical lens array 130 of FIG. 8 in view of shapes of corner light condensing regions. The first corner green light condensing region GLb1, the corner red light condensing region RLb, the corner blue light condensing region BLb, and the second corner green light condensing region GLb2 may each have a square shape, in which the width in the first diagonal direction D1 and the width in the second diagonal direction D2 are nearly the same as each other.

The embodiment may be considered in view of adjusting a ratio between optical efficiencies of the main condensing region and the corner condensing region. In the embodiment, the first corner green light condensing region GLb1, the corner red light condensing region RLb, the corner blue light condensing region BLb, and the second corner green light condensing region GLb2 may have improved optical efficiencies.

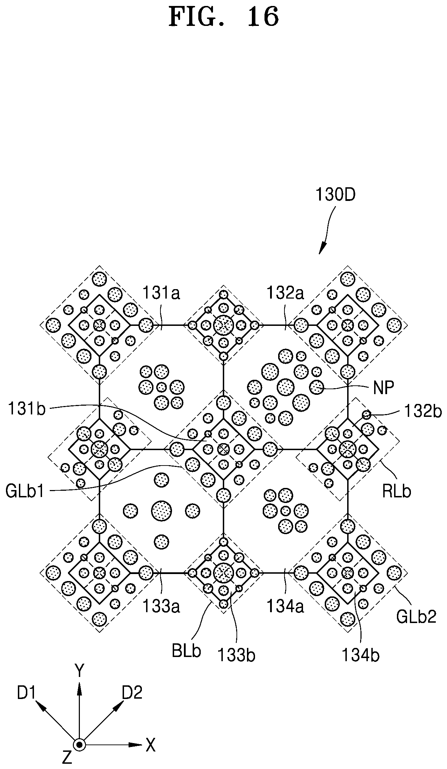

FIG. 16 is a plan view showing an example of an arrangement of a plurality of nano-structures in a nano-optical lens array 130D according to another embodiment.

The nano-optical lens array 130D of the embodiment may include corner green light condensing regions that have square shapes, and the first corner green light condensing region GLb1 and the second corner green light condensing region GLb2 may have increased areas as compared with those in the nano-optical lens array 130C of FIG. 15.

The corner red light condensing region RLb may be rectangular unlike in the nano-optical lens array 130C of FIG. 15, and the corner blue light condensing region BLb may have a reduced square shape as compared with the nano-optical lens array 130C of FIG. 15. However, one or more embodiments are not limited thereto, and in another embodiment, the corner red light condensing region RLb may have a reduced square shape as compared with the nano-optical lens array 130C of FIG. 15, and the corner blue light condensing region BLb may have a rectangular shape.

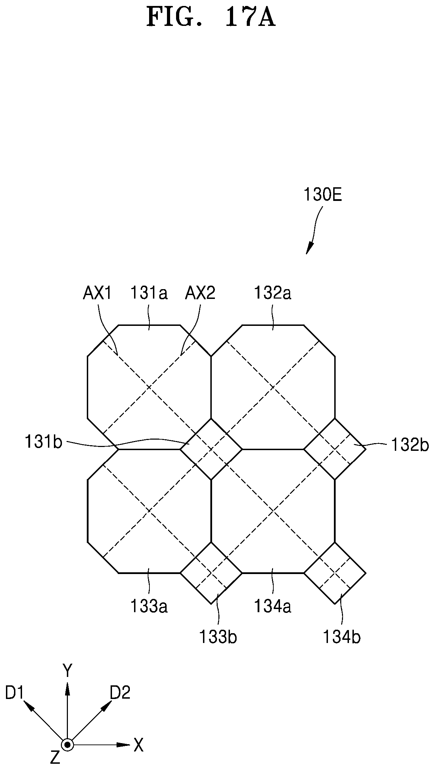

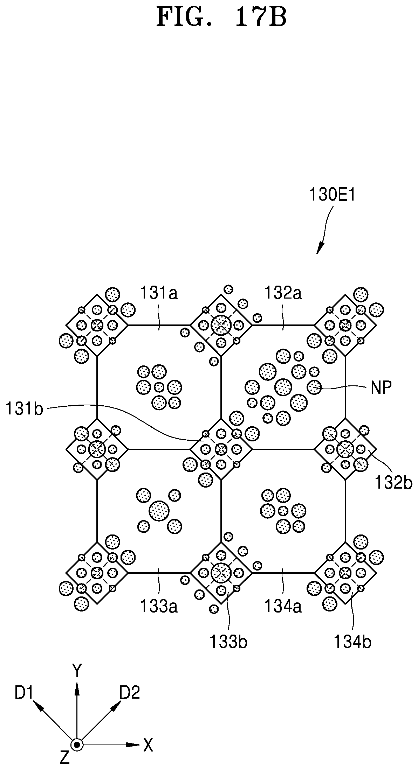

FIG. 17A is a plan view showing an example of a symmetrical axis applied to an arrangement of a plurality of nano-structures in a nano-optical lens array 130E according to another embodiment, and FIG. 17B is a plan view showing an example of a nano-optical lens array 130E1 in which the nano-structures are arranged based on the same symmetric axis as FIG. 17A.

The first main meta-region 131a, the second main meta-region 132a, the third main meta-region 133a, and the fourth main meta-region 134a may each have the first axis AX1 and the second axis AX2 that are defined to pass through the center thereof and to be parallel to the first diagonal direction D1 and the second diagonal direction D2.

The nano-structures NP arranged in each of the first main meta-region 131a, the second main meta-region 132a, the third main meta-region 133a, the fourth main meta-region 134a, the first corner meta-region 131b, the second corner meta-region 132b, the third corner meta-region 133b, and the fourth corner meta-region 134b may be arranged to have symmetry with respect to the first axis AX1 and the second axis AX2 thereof.

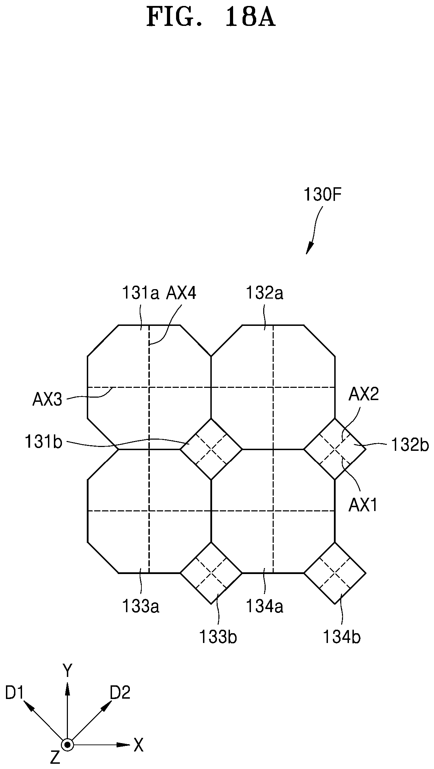

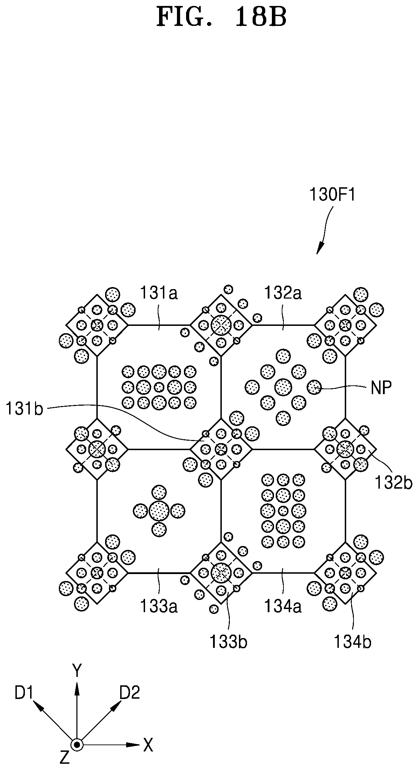

FIG. 18A is a plan view showing an example of a symmetrical axis applied to an arrangement of a plurality of nano-structures in a nano-optical lens array 130F according to another embodiment, and FIG. 18B is a plan view showing an example of a nano-optical lens array 130F1 in which the nano-structures are arranged based on the same symmetric axis as FIG. 18A.

The first main meta-region 131a, the second main meta-region 132a, the third main meta-region 133a, and the fourth main meta-region 134a may each have a third axis AX3 and a fourth axis AX4 that are defined to pass through the center thereof and to be parallel to the first direction (X-direction) and the second direction (Y-direction).

The nano-structures NP arranged in the first main meta-region 131a, the second main meta-region 132a, the third main meta-region 133a, and the fourth main meta-region 134a may be arranged to have symmetry with respect to the third axis AX3 and the fourth axis AX4.

The nano-structures NP arranged in the first corner meta-region 131b, the second corner meta-region 132b, the third corner meta-region 133b, and the fourth corner meta-region 134b may be arranged to have symmetry with respect to the fist axis AX1 and the second axis AX2.

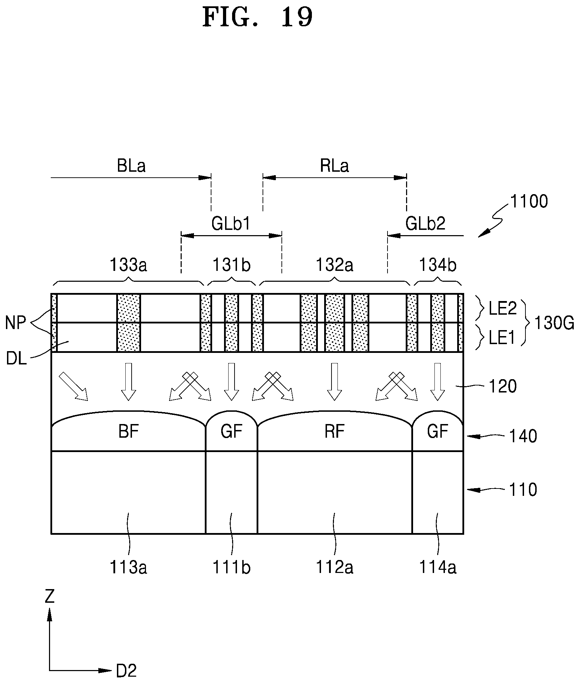

FIG. 19 is a cross-sectional view of a pixel array in an image sensor including a nano-optical lens array 130G according to another embodiment.

The nano-optical lens array 130G may have nano-structures in a dual-layered structure. For example, the nano-structures NP in the nano-optical lens array 130G may be arranged separately in a first lens layer LE1 and a second lens layer LE2.

Although not shown in the drawings, an etch-stop layer may be further disposed between the first lens layer LE1 and the second lens layer LE2. The etch-stop layer may be provided to prevent damage to the first lens layer LE1 while manufacturing the second lens layer LE2. When forming the second lens layer LE2 on the first lens layer LE1, the dielectric layer DL may be entirely formed on the first lens layer LE1, and then, may be etched to a certain depth. Here, the dielectric layer DL may be etched deeper than the desired depth, and thus, the first lens layer LE1 may be damaged, and when the height of the first lens layer LE1 is not suitable for a desired height regulation, the color-separation performance may be degraded. The etch-stop layer formed on the first lens layer LE1 may include a material having a lower etch selectivity than that of a material layer that is to be etched, and may not be completely removed during the etching process but partially remain. Then, the damage to the first lens layer LE1 may be prevented. The etch-stop layer may include, for example, HfO₂. The thickness of the etch-stop layer may be determined in consideration of the etched depth, that is, the height of the second lens layer LE2, and may be also determined based on an etching dispersion in a processed wafer. For example, the etch-stop layer may have a thickness of about 3 nm to about 30 nm.

The nano-structures NP in the first lens layer LE1 and the second lens layer LE2 are shown to have the same arrangement, but one or more embodiments are not limited thereto. By arranging the nano-structures in two layers, an aspect ratio of the nano-structures NP may be substantially increased, and a degree of freedom in designing the nano-structures NP 130C may be improved.

The image sensor 1000 according to the embodiment may form a camera module along with a module lens of various functions and may be utilized in various electronic apparatuses.

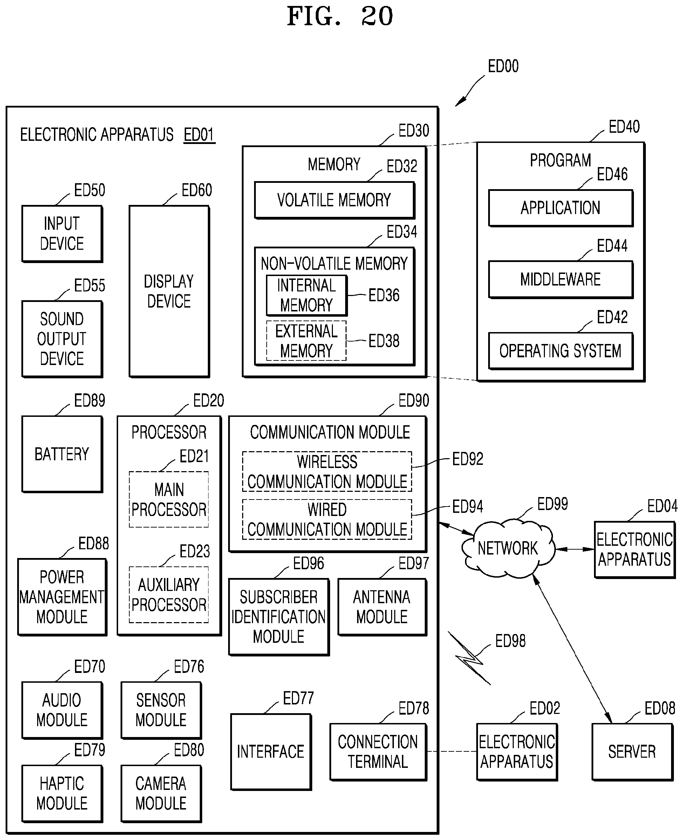

FIG. 20 is a block diagram showing an example of an electronic apparatus ED01 including the image sensor 1000. Referring to FIG. 20, in a network environment ED00, the electronic apparatus ED01 may communicate with another electronic apparatus ED02 via a first network ED98 (e.g., short-range wireless communication network, etc.), and/or may communicate with another electronic apparatus ED04 and/or a server ED08 via a second network ED99 (e.g., long-range wireless communication network, etc.). The electronic apparatus ED01 may communicate with the electronic apparatus ED04 via the server ED08. The electronic apparatus ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. In the electronic apparatus ED01, some of elements (e.g., the display device ED60, etc.) may be omitted and/or another element may be added. Some of the elements may be configured as one integrated circuit. For example, the sensor module ED76 (e.g., a fingerprint sensor, an iris sensor, an illuminance sensor, etc.) may be embedded and implemented in the display device ED60 (e.g., display, etc.).

The processor ED20 may control one or more elements (e.g., hardware, software elements, etc.) of the electronic apparatus ED01 connected to the processor ED20 by executing software (e.g., program ED40, etc.) and may perform various data processing and/or operations. As a part of the data processing and/or operations, the processor ED20 may load a command and/or data received from another element (e.g., sensor module ED76, communication module ED90, etc.) to a volatile memory ED32, may process the command and/or data stored in the volatile memory ED32, and may store result data in a non-volatile memory ED34. The non-volatile memory ED34 may include an internal memory ED36 and an external memory ED38. The processor ED20 may include a main processor ED21 a (e.g., central processing unit, an application processor, etc.) and an auxiliary processor ED23 (e.g., a graphics processing unit, an image signal processor, a sensor hub processor, a communication processor, etc.) that may operate independently from and/or along with the main processor ED21. The auxiliary processor ED23 may use less power than that of the main processor ED21 and may perform specific functions.

The auxiliary processor ED23, on behalf of the main processor ED21 while the main processor ED21 is in an inactive state (e.g., sleep state) or along with the main processor ED21 while the main processor ED21 is in an active state (e.g., application execution state), may control functions and/or states related to some (e.g., the display device ED60, the sensor module ED76, the communication module ED90, etc.) of the elements in the electronic apparatus ED01. The auxiliary processor ED23 (e.g., an image signal processor, a communication processor, etc.) may be implemented as a part of another element (e.g., the camera module ED80, the communication module ED90, etc.) that is functionally related thereto.

The memory ED30 may store various data required by the elements (e.g., the processor ED20, the sensor module ED76, etc.) of the electronic apparatus ED01. The data may include, for example, input data and/or output data about software (e.g., program ED40, etc.) and commands related thereto. The memory ED30 may include the volatile memory ED32 and/or the non-volatile memory ED34.

The program ED40 may be stored as software in the memory ED30 and may include an operation system ED42, middleware ED44, and/or an application ED46.

The input device ED50 may receive commands and/or data to be used in the elements (e.g., the processor ED20, etc.) of the electronic apparatus ED01, from outside (e.g., a user, etc.) of the electronic apparatus ED01. The input device ED50 may include a microphone, a mouse, a keyboard, and/or a digital pen (e.g., stylus pen).

The sound output device ED55 may output a sound signal to outside of the electronic apparatus ED01. The sound output device ED55 may include a speaker and/or a receiver. The speaker may be used for a general purpose such as multimedia reproduction and/or record play, and the receiver may be used to receive a call. The receiver may be coupled as a part of the speaker or may be implemented as an independent device.

The display device ED60 may provide visual information to outside of the electronic apparatus ED01. The display device ED60 may include a display, a hologram device, and/or a projector, and a control circuit for controlling the corresponding device. The display device ED60 may include touch circuitry set to sense a touch, and/or a sensor circuit (e.g., pressure sensor, etc.) that is set to measure the strength of a force generated by the touch.

The audio module ED70 may convert sound into an electrical signal or vice versa. The audio module ED 70 may acquire sound through the input device ED50, or may output sound via the sound output device ED55 and/or a speaker and/or headphones of another electronic apparatus (e.g., the electronic apparatus ED02, etc.) connected directly or wirelessly to the electronic apparatus ED01.

The sensor module ED76 may sense an operating state (e.g., power, temperature, etc.) of the electronic apparatus ED01, or an outer environmental state (e.g., user state, etc.) and may generate an electrical signal and/or data value corresponding to the sensed state. The sensor module ED76 may include a gesture sensor, a gyro-sensor, a pressure sensor, a magnetic sensor, an acceleration sensor, a grip sensor, a proximity sensor, a color sensor, an infrared (IR) ray sensor, a vivo sensor, a temperature sensor, a humidity sensor, and/or an illuminance sensor.

The interface ED77 may support one or more designated protocols that may be used in order for the electronic apparatus ED01 to be directly or wirelessly connected to another electronic apparatus (e.g., the electronic apparatus ED02, etc.) The interface ED77 may include a high-definition multimedia interface (HDMI), a universal serial bus (USB) interface, a secure digital (SD) card interface, and/or an audio interface.

The connection terminal ED78 may include a connector by which the electronic apparatus ED01 may be physically connected to another electronic apparatus (e.g., the electronic apparatus ED02, etc.). The connection terminal ED78 may include an HDMI connector, a USB connector, an SD card connector, and/or an audio connector (e.g., headphones connector, etc.).

The haptic module ED79 may convert the electrical signal into a mechanical stimulation (e.g., vibration, motion, etc.) or an electric stimulation that the user may sense through a tactile or motion sensation. The haptic module ED79 may include a motor, a piezoelectric device and/or an electric stimulus device.

The camera module ED80 may capture a still image and/or a video. The camera module ED80 may include a lens assembly including one or more lenses, the image sensor 1000 of FIG. 1, image signal processors, and/or flashes. The lens assembly included in the camera module ED80 may collect light emitted from an object that is an object to be captured.

The power management module ED88 may manage the power supplied to the electronic apparatus ED01. The power management module ED88 may be implemented as a part of a power management integrated circuit (PMIC).

The battery ED89 may supply electric power to components of the electronic apparatus ED01. The battery ED89 may include a primary battery that is not rechargeable, a secondary battery that is rechargeable, and/or a fuel cell.

The communication module ED90 may support the establishment of a direct (wired) communication channel and/or a wireless communication channel between the electronic apparatus ED01 and another electronic apparatus (e.g., the electronic apparatus ED02, the electronic apparatus ED04, the server ED08, etc.), and execution of communication through the established communication channel. The communication module ED90 may be operated independently from the processor ED20 (e.g., application processor, etc.) and may include one or more communication processors that support the direct communication and/or the wireless communication. The communication module ED90 may include a wireless communication module ED92 (e.g., a cellular communication module, a short-range wireless communication module, a global navigation satellite system (GNSS) communication module) and/or a wired communication module ED94 (e.g., a local area network (LAN) communication module, a power line communication module, etc.). From among the communication modules, a corresponding communication module may communicate with another electronic apparatus via the first network ED98 (e.g., short-range communication network such as Bluetooth^{™}, WiFi direct, or infrared data association (IrDA)) or a second network ED99 (e.g., long-range communication network such as a cellular network, Internet, or computer network (e.g., LAN, wide area network (WAN), etc.)). Such above various kinds of communication modules may be integrated as one element (e.g., single chip, etc.) or may be implemented as a plurality of elements (e.g., a plurality of chips) separately from one another. The wireless communication module ED92 may identify and authenticate the electronic apparatus ED01 in a communication network such as the first network ED98 and/or the second network ED99 by using subscriber information (e.g., international mobile subscriber identifier (IMSI), etc.) stored in the subscriber identification module ED96.

The antenna module ED97 may transmit or receive the signal and/or power to/from outside (e.g., another electronic apparatus, etc.). An antenna may include a radiator formed as a conductive pattern formed on a substrate (e.g., printed circuit board (PCB), etc.). The antenna module ED97 may include one or more antennas. When the antenna module ED97 includes a plurality of antennas, from among the plurality of antennas, an antenna that is suitable for the communication type used in the communication network such as the first network ED98 and/or the second network ED99 may be selected by the communication module ED90. The signal and/or the power may be transmitted between the communication module ED90 and another electronic apparatus via the selected antenna. Another component (e.g., a radiofrequency integrated circuit (RFIC), etc.) other than the antenna may be included as a part of the antenna module ED97.

Some of the elements may be connected to one another via the communication method among the peripheral devices (e.g., bus, general purpose input and output (GPIO), serial peripheral interface (SPI), mobile industry processor interface (MIPI), etc.) and may exchange signals (e.g., commands, data, etc.).

The command and/or data may be transmitted and/or received between the electronic apparatus ED01 and the external electronic apparatus ED04 via the server ED08 connected to the second network ED99. Other electronic apparatuses ED02 and ED04 may be the devices that are the same as or different kinds from the electronic apparatus ED01. All or some of the operations executed in the electronic apparatus ED01 may be executed in one or more devices among the other electronic apparatuses ED02, ED04, and ED08. For example, when the electronic apparatus ED01 has to perform a certain function and/or service, the electronic apparatus ED01 may request one or more other electronic apparatuses to perform some or entire function or service, instead of executing the function and/or service by itself. One or more electronic apparatuses receiving the request execute an additional function and/or service related to the request and may transfer a result of the execution to the electronic apparatus ED01. To do this, for example, a cloud computing, a distributed computing, and/or a client-server computing technique may be used.

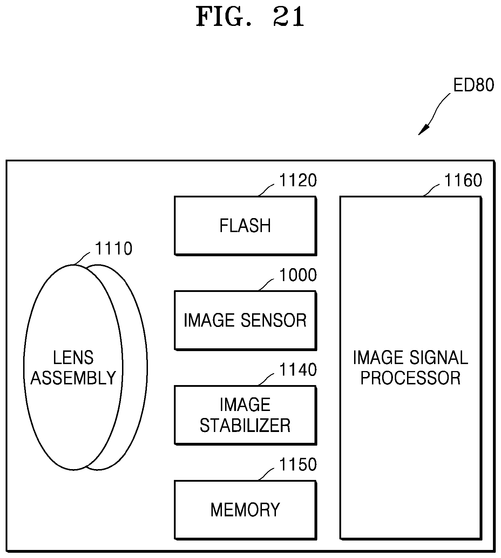

FIG. 21 is a block diagram showing an example of the camera module ED80 included in the electronic apparatus ED01 of FIG. 20. Referring to FIG. 20, the camera module ED80 may include a lens assembly 1110, a flash 1120, an image sensor 1000, an image stabilizer 1140, a memory 1150 (e.g., buffer memory, etc.), and/or an image signal processor 1160. The lens assembly 1110 may collect light emitted from an object that is to be captured. The camera module ED80 may include a plurality of lens assemblies 1110, and in this case, the camera module ED80 may include a dual camera module, a 360-degree camera, or a spherical camera. Some of the plurality of lens assemblies 1110 may have the same lens properties (e.g., viewing angle, focal length, auto-focus, F number, optical zoom, etc.) or different lens properties. The lens assembly 1110 may include a wide-angle lens or a telephoto lens.

The flash 1120 may emit light that is used to strengthen the light emitted or reflected from the object. The flash 1120 may emit visible light or infrared-ray light. The flash 1120 may include one or more light-emitting diodes (e.g., red-green-blue (RGB)) light-emitting diode (LED), white LED, infrared LED, ultraviolet LED, etc.), and/or a Xenon lamp. The image sensor 1000 may be the image sensor described above with reference to FIG. 1, and may convert the light emitted or reflected from the object and transferred through the lens assembly 1110 into an electrical signal to obtain an image corresponding to the object.

The image stabilizer 1140, in response to a motion of the camera module ED80 or the electronic apparatus 1101 including the camera module ED80, may move one or more lenses included in the lens assembly 1110 and/or the image sensor 1000 in a certain direction and/or control the operating characteristics (e.g., adjusting of a read-out timing, etc.) of the image sensor 1000 in order to compensate for a negative influence of the motion. The image stabilizer 1140 may sense the movement of the camera module ED80 and/or the electronic apparatus ED01 by using a gyro sensor (not shown) and/or an acceleration sensor (not shown) disposed in or out of the camera module ED80. The image stabilizer 1140 may be implemented as an optical type.

The memory 1150 may store some or entire data of the image obtained through the image sensor 1000 for next image processing operation. For example, when a plurality of images are obtained at a high speed, obtained original data (e.g., Bayer-patterned data, high-resolution data, etc.) may be stored in the memory 1150, and a low-resolution image may be displayed. Then, original data of a selected image (e.g., user selection, etc.) may be transferred to the image signal processor 1160. The memory 1150 may be integrated with the memory ED30 of the electronic apparatus ED01, and/or may include an additional memory that is operated independently.

An image signal processor 1160 may obtain an image by using electrical signals output from the image sensor 1000. The image signal processor 1160 may request image data of a certain format from the image sensor 1000 according to the format of the necessary image data.

The image signal processor 1160 may perform additional image processes on the image obtained through the image sensor 1000 or the image data stored in the memory 1150. The image processing may include a depth map generation, a three-dimensional modeling, a panorama generation, extraction of features, an image combination, and/or an image compensation (e.g., noise reduction, resolution adjustment, brightness adjustment, blurring, sharpening, softening, etc.). The image signal processor 1160 may perform controlling (e.g., exposure time control, read-out timing control, etc.) of the elements (e.g., image sensor 1000, etc.) included in the camera module ED80.

The image processed by the image signal processor 1160 may be stored again in the memory 1150 for additional process, and/or may be provided to an external element of the camera module ED80 (e.g., the memory ED30, the display device ED60, the electronic apparatus ED02, the electronic apparatus ED04, the server ED08, etc.). The image signal processor 1160 may be integrated with the processor ED20, or may be configured as an additional processor that is independently operated from the processor ED20. When the image signal processor 1160 is configured as an additional processor separately from the processor ED20, the image processed by the image signal processor 1160 may undergo an additional image processing by the processor ED20 and then may be displayed on the display device ED60.

The image signal processor 1160 may receive two output signals independently from the adjacent photosensitive cells in each pixel and/or sub-pixel of the image sensor 1000, and may generate an auto-focusing signal from a difference between the two output signals. The image signal processor 1160 may control the lens assembly 1110 such that the focus of the lens assembly 1110 may be accurately formed on the surface of the image sensor 1000 based on the auto-focusing signal.

The electronic apparatus ED01 may further include one or a plurality of camera modules having different properties and/or functions. The camera module may include elements similar to those of the camera module ED80 of FIG. 21, and the image sensor included in the camera module may be implemented as a CCD sensor and/or a CMOS sensor and may include one or a plurality of sensors selected from the image sensors having different properties, such as an RGB sensor, a black and white (BW) sensor, an IR sensor, or a ultraviolet (UV) sensor. In this case, one of the plurality of camera modules ED80 may include a wide-angle camera and another camera module ED80 may include a telephoto camera. Similarly, one of the plurality of camera modules ED80 may include a front camera and another camera module ED80 may include a rear camera.

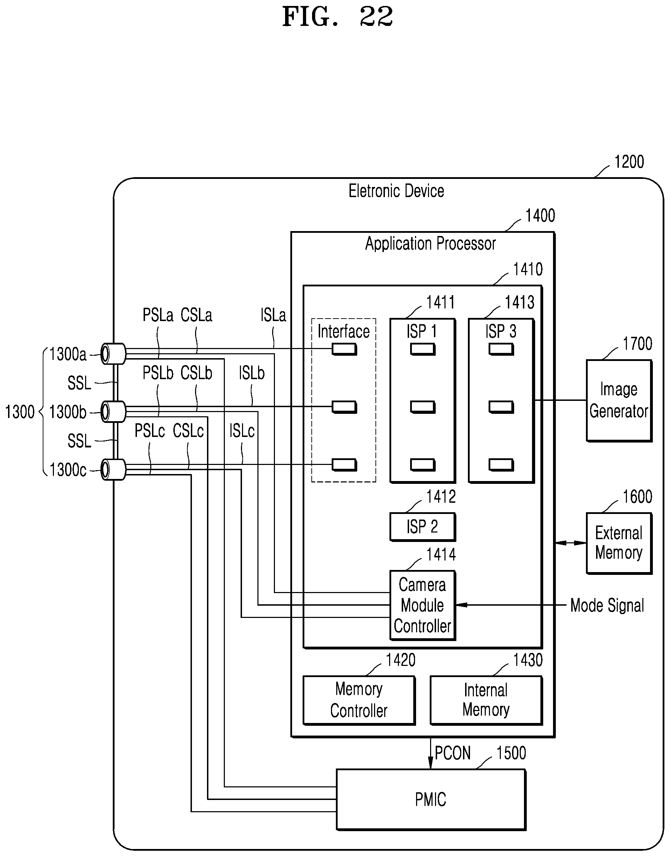

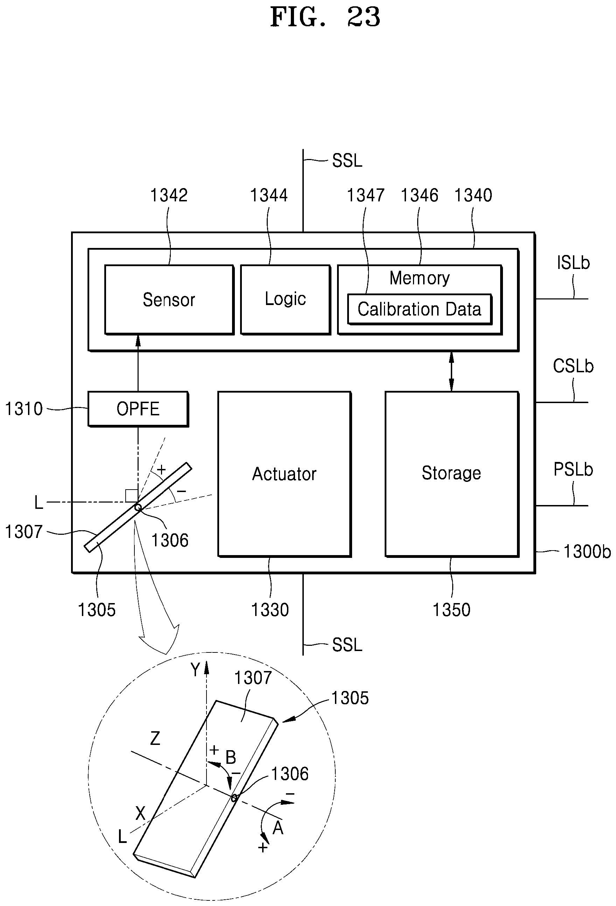

FIG. 22 is a block diagram of an electronic apparatus 1200 including a multi-camera module, and FIG. 23 is a detailed block diagram of the camera module provided in the electronic apparatus shown in FIG. 22.

Referring to FIG. 22, the electronic apparatus 1200 may include a camera module group 1300, an application processor 1400, a power management integrated circuit (PMIC) 1500, an external memory 1600, and an image generator 1700.

The camera module group 1300 may include a plurality of camera modules 1300a, 1300b, and 1300c. Although the drawings show an example in which three camera modules 1300a, 1300b, and 1300c are arranged, one or more embodiments are not limited thereto. In some embodiments, the camera module group 1300 may be modified to include only two camera modules. In some embodiments, the camera module group 1300 may be modified to include n (n is 4 or greater natural number) camera modules.

Hereinafter, detailed configuration of one camera module 1300b is described in detail below with reference to FIG. 22, but the description provided below may be also applied to the other camera modules 1300a and 1300c according to the embodiments.

Referring to FIG. 22, the camera module 1300b may include a prism 1305, an optical path folding element (OPFE) 1310, an actuator 1330, an image sensing device 1340, and a storage 1350.

The prism 1305 may include a reflecting surface 1307 having a light-reflecting material and may deform a path of light L incident from outside.

In some embodiments, the prism 1305 may change the path of the light L incident in the first direction (X-direction) into a second direction (Y-direction) that is perpendicular to the first direction (X-direction). The prism 1305 may rotate the reflecting surface 1307 having the light-reflecting material about a center axis 1106 in a direction A, or about the center axis 1306 in a direction B such that the path of the light L incident in the first direction (X-direction) may be changed to the second direction (Y-direction) perpendicular to the first direction (X-direction). Here, the OPFE 1310 may also move in the third direction (Z-direction) that is perpendicular to the first direction (X-direction) and the second direction (Y-direction).

In some embodiments, as shown in the drawings, the maximum rotation angle of the prism 1305 in the direction A is 15° or less in the positive A direction and is greater than 15° in the negative A direction, but the embodiments are not limited thereto.

In some embodiments, the prism 1305 may be moved by the angle of about 20°, or between 10° to 20° or 15° to 20° in the positive or negative B direction. Here, the moving angle is the same in the positive or negative B direction, or may be similar within a range of about 1°.

In some embodiments, the prism 1305 may move the reflecting surface 1307 of the light-reflective material in the third direction (e.g., Z direction) that is parallel to the direction in which the center axis 1306 extends.

The OPFE 1310 may include, for example, optical lenses formed as m groups (here, m is a natural number). Here, m lenses move in the second direction (Y-direction) and may change an optical zoom ratio of the camera module 1300b. For example, when a basic optical zoom ratio of the camera module 1300b is Z and m optical lenses included in the OPFE 1310 move, the optical zoom ratio of the camera module 1300b may be changed to 3Z, 5Z, or 10Z or greater.

The actuator 1330 may move the OPFE 1310 or the optical lens (hereinafter, referred to as optical lens) to a certain position. For example, the actuator 1330 may adjust the position of the optical lens such that the image sensor 1342 may be located at a focal length of the optical lens for exact sensing operation.

An image sensing device 1340 may include the image sensor 1342, a control logic 1344, and a memory 1346. The image sensor 1342 may sense an image of a sensing target by using the light L provided through the optical lens. The control logic 1344 may control the overall operation of the camera module 1300b. For example, the control logic 1344 may control the operations of the camera module 1300b according to a control signal provided through a control signal line CSLb.

The memory 1346 may store information that is necessary for the operation of the camera module 1300b, e.g., calibration data 1347. The calibration data 1347 may include information that is necessary to generate image data by using the light L provided from outside through the camera module 1300b. The calibration data 1347 may include, for example, information about the degree of rotation described above, information about the focal length, information about an optical axis, etc. When the camera module 1300b is implemented in the form of a multi-state camera of which the focal length is changed according to the position of the optical lens, the calibration data 1347 may include information related to focal length values of the optical lens according to each position (or state) and auto-focusing.

The storage unit 1350 may store image data sensed through the image sensor 1342. The storage unit 1350 may be disposed out of the image sensing device 1340 and may be stacked with a sensor chip included in the image sensing device 1340. In some embodiments, the storage unit 1350 may be implemented as electrically erasable programmable read-only memory (EEPROM), but one or more embodiments are not limited thereto.

Referring to FIGS. 22 and 23, in some embodiments, each of the plurality of camera modules 1300a, 1300b, and 1300c may include the actuator 1330. Accordingly, each of the plurality of camera modules 1300a, 1300b, and 1300c may include the calibration data 1347 that is the same as or different from the others, according to the operation of the actuator 1330 included therein.

In some embodiments, one (for example, 1300b) of the plurality of camera modules 1300a, 1300b, and 1300c may be a camera module in a folded lens type including the prism 1305 and the OPFE 1310 described above, and the other camera modules (for example, 1300a and 1300c) may be vertical type camera modules not including the prism 1305 and the OPFE 1310. However, the disclosure is not limited thereto.

In some embodiments, one (for example, 1300c) of the plurality of camera modules 1300a, 1300b, and 1300c may be a depth camera of a vertical type, which extracts depth information by using infrared ray (IR).

In some embodiments, at least two camera modules (e.g., 1300a and 1300b) from among the plurality of camera module 1300a, 1300b, and 1300c may have different fields of view. In this case, for example, the optical lenses of the at least two camera modules (e.g., 1300a and 1300b) from among the plurality of camera modules 1300a, 1300b, and 1300c may be different from each other, but one or more embodiments are not limited thereto.

In some embodiments, the plurality of camera modules 1300a, 1300b, and 1300c may have different fields of view from one another. In this case, the optical lenses respectively included in the plurality of camera modules 1300a, 1300b, and 1300c may be different from one another, but the inventive concept is not limited thereto.

In some embodiments, the plurality of camera modules 1300a, 1300b, and 1300c may be physically isolated from one another. That is, the sensing region of one image sensor 1342 may not be divided and used by the plurality of camera modules 1300a, 1300b, and 1300c, but the plurality of camera modules 1300a, 1300b, and 1300c may each have an independent image sensor 1342 provided therein.

Referring back to FIG. 22, the application processor 1400 may include an image processing device 1410, a memory controller 1420, and an internal memory 1430. The application processor 1400 may be separately implemented from the plurality of camera modules 1300a, 1300b, and 1300c. For example, the application processor 1400 and the plurality of camera modules 1300a, 1300b, and 1300c may be separately implemented as separate semiconductor chips.

The image processing device 1410 may include a plurality of image processors 1411, 1412, and 1413, and a camera module controller 1414.

The image data generated by each of the camera modules 1300a, 1300b, and 1300c may be provided to the image processing device 1410 via separate image signal lines ISLa, ISLb, and ISLc, respectively. The image data transfer may be carried out by using a camera serial interface (CSI) based on a mobile industry processor interface (MIPI), for example, but is not limited thereto.

The image data transferred to the image processing device 1410 may be stored in an external memory 1600 before being transferred to the image processors 1411 and 1412. The image data stored in the external memory 1600 may be provided to the image processor 1411 and/or the image processor 1412. The image processor 1411 may correct the image data in order to generate video. The image processor 1412 may correct the image data in order to generate still images. For example, the image processors 1411 and 1412 may perform a pre-processing operation such as a color calibration, a gamma calibration on the image data.

The image processor 1411 may include sub-processors. When the number of sub-processors is equal to the number of camera modules 1300a, 1300b, and 1300c, each of the sub-processors may process the image data provided from one camera module. When the number of sub-processors is less than the number of camera modules 1300a, 1300b, and 1300c, at least one of the sub-processors may process the image data provided from a plurality of camera module by using a timing-sharing process. The image data processed by the image processor 1411 and/or the image processor 1412 may be stored in the external memory 1600 before being transferred to the image processor 1413. The image data stored in the external memory 1600 may be transferred to the image processor 1412. The image processor 1412 may perform a post-processing operation such as a noise calibration, a sharpen calibration, etc. on the image data.

The image data processed in the image processor 1413 may be provided to the image generator 1700. The image generator 1700 may generate a final image by using the image data provided from the image processor 1413 according to image generating information or a mode signal.

In detail, the image generator 1700 may generate an output image by merging at least parts of the image data generated by the camera modules 1300a, 1300b, and 1300c having different fields of view, according to image generating information or the mode signal. The image generator 1700 may generate the output image by selecting one of pieces of image data generated by the camera modules 1300a, 1300b, and 1300c having different fields of view, according to image generating information or the mode signal.

In some embodiments, the image generating information may include a zoom signal or a zoom factor. In some embodiments, the mode signal may be, for example, a signal based on a mode selected by a user.

When the image generating information is a zoom signal (or zoom factor) and the camera modules 1300a, 1300b, and 1300c have different fields of view (or angles of view) from one another, the image generator 1700 may perform different operations according to the kind of zoom signal. For example, when the zoom signal is a first signal, the image data output from the camera module 1300a is merged with the image data output from the camera module 1300c, and then, the output image may be generated by using the merged image signal and the image data output from the camera module 1300b and not used in the merge. When the zoom signal is a second signal that is different from the first signal, the image generator 1700 may not perform the image data merging, and then, may generate the output image by selecting one piece of the image data output respectively from the camera modules 1300a, 1300b, and 1300c. However, one or more embodiments are not limited thereto, and the method of processing the image data may be modified as necessary.

The camera module controller 1414 may provide each of the camera modules 1300a, 1300b, and 1300c with a control signal. The control signals generated by the camera module controller 1414 may be provided to corresponding camera modules 1300a, 1300b, and 1300c via control signal lines CSLa, CSLb, and CSLc separated from one another.

In some embodiments, the control signal provided to the plurality of camera modules 1300a, 1300b, and 1300c from the camera module controller 1414 may include mode information according to the mode signal. The plurality of camera modules 1300a, 1300b, and 1300c may operate in a first operation mode and a second operation mode in relation to the sensing speed, based on the mode information.

In the first operation mode, the plurality of camera modules 1300a, 1300b, and 1300c may generate the image signal at a first speed (for example, generating an image signal of a first frame rate), encodes the image signal at a second speed that is faster than the first speed (for example, encoding the image signal of a second frame rate that is greater than the first frame rate), and transfers the encoded image signal to the application processor 1400. Here, the second speed may be 30 times faster than the first speed or less.

The application processor 1400 may store the received image signal, that is, the encoded mage signal, in the internal memory 1430 provided therein or the external memory 1600 outside the application processor 1400, and after that, reads and decodes the encoded signal from the internal memory 1430 or the external memory1600, and may display the image data generated based on the decoded image signal. For example, the image processors 1411 and 1412 in the image processing device 1410 may perform decoding, and may perform image processing on the decoded image signals.

In the second operation mode, the plurality of camera modules 1300a, 1300b, and 1300c generates an image signal at a third speed that is slower than the first speed (for example, generating the image signal of a third frame rate that is lower than the first frame rate), and may transfer the image signal to the application processor 1400. The image signal provided to the application processor 1400 may be a signal that is not encoded. The application processor 1400 may perform the image processing of the received image signal or store the image signal in the internal memory 1430 or the external memory1600.

The PMIC 1500 may supply the power, for example, the power voltage, to each of the plurality of camera modules 1300a, 1300b, and 1300c. For example, the PMIC 1500 may supply the first power to the camera module 1300a via a power signal line PSLa, the second power to the camera module 1300b via a power signal line PSLb, and the third power to the camera module 1300c via a power signal line PSLc, under the control of the application processor 1400.

The PMIC 1500 may generate the power corresponding to each of the plurality of camera modules 1300a, 1300b, and 1300c and may adjust the power level, in response to a power control signal PCON from the application processor 1400. The power control signal PCON may include a power adjusting signal for each operation mode of the plurality of camera modules 1300a, 1300b, and 1300c. For example, the operation mode may include a low power mode, and the power control signal PCON may include information about the camera module operating in the low-power mode and set power level. The levels of the power provided to the plurality of camera modules 1300a, 1300b, and 1300c may be equal to or different from each other. The power level may be dynamically changed.

An image sensor according to an embodiment includes a nano-optical lens array performing both color separation and light condensing functions, and thus, light utilization efficiency may be improved.

Due to the nano-optical lens array provided in the image sensor according to the embodiment, light of a corresponding color may be efficiently separated and condensed onto adjacent pixels in a diagonal direction, which have different sizes and have same or different colors.

The image sensor according to the embodiment may dynamically utilize pixels in a low-luminance environment and a high-luminance environment, and may be applied to, for example, a high dynamic range (HDR) sensor, etc.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims and their equivalents.

## Claims

1. An image sensor comprising:
a sensor substrate including a plurality of photosensitive elements; and
a nano-optical lens array including a plurality of nano-structures and being configured to separate, from an incident light, a light of a first wavelength band, a light of a second wavelength band that is different from the first wavelength band, and a light of a third wavelength band that is different from the first wavelength band and the second wavelength band, and condense the separated lights respectively onto the plurality of photosensitive elements,
wherein the plurality of photosensitive elements include a first main photosensitive element and a first corner photosensitive element configured to each sense the light of the first wavelength band and arranged adjacent to each other in a first diagonal direction, the first corner photosensitive element having a size less than a size of the first main photosensitive element,
wherein the nano-optical lens array includes a first main meta-region corresponding to the first main photosensitive element and a first corner meta-region corresponding to the first corner photosensitive element, and
wherein nano-structures in the first corner meta-region are arranged to have a symmetry based on a first axis and a second axis as symmetric axes, the first axis passing through a center of the first corner meta-region and being parallel to the first diagonal direction and the second axis passing through the center of the first corner meta-region and being parallel to a second diagonal direction that is different from the first diagonal direction.

2. The image sensor of claim 1, wherein the nano-structures in the first corner meta-region are arranged such that a size distribution thereof on the first axis is different from a size distribution thereof on the second axis.

3. The image sensor of claim 1 or 2, wherein, in the first corner meta-region, a number of nano-structures located on the first axis is different from a number of nano-structures located on the second axis.

4. The image sensor of any preceding claim, wherein the plurality of photosensitive elements further include:
a second main photosensitive element and a second corner photosensitive element, each being configured to sense the light of the second wavelength band;
a third main photosensitive element and a third corner photosensitive element, each being configured to sense the light of the third wavelength band; and
a fourth main photosensitive element and a fourth corner photosensitive element, each being configured to sense the light of the first wavelength band,
wherein the first to the fourth main photosensitive elements are arranged in a 2x2 array in a first direction forming an angle of 45° with respect to the second diagonal direction and a second direction perpendicular to the first direction,
wherein the second corner photosensitive element is arranged adjacent to the second main photosensitive element in the first diagonal direction,
wherein the third corner photosensitive element is arranged adjacent to the third main photosensitive element in the first diagonal direction, and
wherein the fourth corner photosensitive element is arranged adjacent to the fourth main photosensitive element in the first direction.

5. The image sensor of claim 4, wherein the nano-optical lens array further includes:
a second main meta-region corresponding to the second main photosensitive element, and
a second corner meta-region corresponding to the second corner photosensitive element, and
wherein nano-structures in the second corner meta-region are arranged to have a symmetry based on a third axis and a fourth axis as symmetric axes, the third axis passing through a center of the second corner meta-region and being parallel to the first diagonal direction and the fourth axis passing through the center of the second corner meta-region and being parallel to the second diagonal direction, and optionally wherein the nano-structures in the second corner meta-region are arranged such that a size distribution thereof on the third axis is different from a size distribution thereof on the fourth axis.

6. The image sensor of claim 4 or 5, wherein the nano-optical lens array further includes:
a third main meta-region corresponding to the third main photosensitive element; and
a third corner meta-region corresponding to the third corner photosensitive element, and
wherein nano-structures in the third corner meta-region are arranged to have a symmetry based on a fifth axis and a sixth axis as symmetric axes, the fifth axis passing through a center of the third corner meta-region and being parallel to the first diagonal direction and the sixth axis passing through the center of the third corner meta-region and being parallel to the second diagonal direction, and
wherein a size distribution of the nano-structures in the third corner meta-region on the fifth axis is different from a size distribution thereof on the sixth axis.

7. The image sensor of claim 4, 5 or 6, wherein the nano-optical lens array further includes:
a fourth main meta-region corresponding to the fourth main photosensitive element; and
a fourth corner meta-region corresponding to the fourth corner photosensitive element;
wherein an arrangement of the nano-structures in the first main meta-region is the same as an arrangement of nano-structures in the fourth main meta-region, and
wherein an arrangement of the nano-structures in the first corner meta-region is the same as an arrangement of nano-structures in the fourth corner meta-region.

8. The image sensor of any of claims 4 to 7, wherein each of the first main photosensitive element and the fourth main photosensitive element is configured to sense a green light,
wherein the second main photosensitive element is configured to sense a red light, and
wherein the third main photosensitive element is configured to sense a blue light, and optionally wherein the nano-optical lens array further includes:
a first main green light condensing region configured to condense the green light onto the first main photosensitive element;
a first corner green light condensing region configured to condense the green light onto the first corner photosensitive element;
a main red light condensing region configured to condense the red light onto the second main photosensitive element;
a corner red light condensing region configured to condense the red light onto the second corner photosensitive element;
a main blue light condensing region configured to condense the blue light onto the third main photosensitive element; and
a corner blue light condensing region configured to condense the blue light onto the third corner photosensitive element, and further optionally:
wherein a width of the first corner green light condensing region in the first diagonal direction is at least one of:
less than or equal to a width of the first corner meta-region in the first diagonal direction; and
greater than a width of the first corner meta-region in the second diagonal direction.

9. The image sensor of claim 8, wherein a size of the first corner green light condensing region is less than or equal to three times of a size of the first corner meta-region.

10. The image sensor of claim 8 or 9, wherein nano-structures in the first corner green light condensing region are arranged such that a size distribution thereof on the first axis is different from a size distribution thereof on the second axis.

11. The image sensor of any of claims 8 to 10, wherein a width of the first main green light condensing region in the first diagonal direction is greater than or equal to a width of the first main meta-region in the first diagonal direction, and
wherein a width of the first main green light condensing region in the second diagonal direction is greater than a width of the first main meta-region in the second diagonal direction.

12. The image sensor of any of claims 8 to 11, wherein the nano-optical lens array further includes a second corner meta-region corresponding to the second corner photosensitive element,
wherein a size of the corner red light condensing region is greater than a size of the second corner meta-region, and
wherein a width of the corner red light condensing region in the second diagonal direction is greater than or equal to a width of the corner red light condensing region in the first diagonal direction.

13. The image sensor of any of claims 8 to 12, wherein the nano-optical lens array further includes a second main meta-region corresponding to the second main photosensitive element,
wherein a size of the main red light condensing region is greater than a size of the second main meta-region, and
wherein a width of the main red light condensing region in the second diagonal direction is greater than or equal to a width of the main red light condensing region in the first diagonal direction.

14. The image sensor of any of claims 8 to 13, wherein the nano-optical lens array further includes a third corner meta-region corresponding to the third corner photosensitive element,
wherein a size of the corner blue light condensing region is greater than a size of the third corner meta-region, and
wherein a width of the corner blue light condensing region in the second diagonal direction is greater than or equal to a width of the corner blue light condensing region in the first diagonal direction.

15. The image sensor of any preceding claim, wherein the nano-structures in the first main meta-region are arranged:
to have a symmetry based on an axis that passes through a center of the first main meta-region and is parallel to the first diagonal direction and an axis that passes through the center of the first main meta-region and is parallel to the second diagonal direction, as symmetric axes, or
to have a symmetry based on an axis that passes through the center of the first main meta-region and is parallel to a first direction that forms an angle of 45° with respect to the second diagonal direction and an axis that passes through the center of the first main meta-region and is parallel to a second direction perpendicular to the first direction, as symmetric axes.
